(19) Europäisches Patentamt European Patent Office Office européen des brevets

(11) **EP 1 552 600 B1**

(12) **FASCICULE DE BREVET EUROPEEN**

(45) Date de publication et mention de la délivrance du brevet:
**04.06.2008 Bulletin 2008/23**

(21) Numéro de dépôt: **03778388.3**

(22) Date de dépôt: **14.10.2003**

(51) Int Cl.:
*H03B 1/04* *(2006.01)*    *H03L 7/099* *(2006.01)*

(86) Numéro de dépôt international:
**PCT/FR2003/003020**

(87) Numéro de publication internationale:
**WO 2004/038909 (06.05.2004 Gazette 2004/19)**

(54) **Oscillateur controlé en tension comprenant un circuit de compensation de l'éffet d'entrainement en fréquence**

Spannungsgesteuerter Oszillator mit einer Schaltung, um den Effekt des mitziehens der Frequenz auszugleichen

Voltage-controlled oscillator comprising a circuit for compensating frequency pulling

(84) Etats contractants désignés:
**DE FR GB IT**

(30) Priorité: **18.10.2002 FR 0212959**

(43) Date de publication de la demande:
**13.07.2005 Bulletin 2005/28**

(73) Titulaire: **STMicroelectronics S.A.**
**92120 Montrouge (FR)**

(72) Inventeur: **NAYLER, Peter**
**F-38000 Grenoble (FR)**

(74) Mandataire: **Marchand, André**
**OMNIPAT,**
**24 Place des Martyrs de la Résistance**
**13100 Aix-en-Provence (FR)**

(56) Documents cités:
**US-A- 5 144 260       US-B1- 6 321 074**
**US-B1- 6 424 230**

**Description**

La présente invention concerne les oscillateurs contrôlés en tension ou VCO ("Voltage Controlled Oscillator").

La présente invention concerne plus particulièrement un circuit RF comprenant un oscillateur contrôlé en tension délivrant un signal RF, une boucle à verrouillage de phase pour contrôler l'oscillateur contrôlé en tension, un circuit de modulation recevant le signal RF et délivrant un signal modulé comprenant au moins une composante harmonique RF susceptible de perturber l'oscillateur contrôlé en tension par effet d'accrochage en fréquence.

Dans les circuits radiofréquence utilisant des VCO, des phénomènes de fuite de signaux harmoniques dégradent les performances des VCO, en raison d'un effet d'accrochage en fréquence généralement appelé "injection pulling" ou "injection locking" .

La présente invention vise la suppression, à tout le moins la diminution, de l'effet d'accrochage en fréquence dans les VCO.

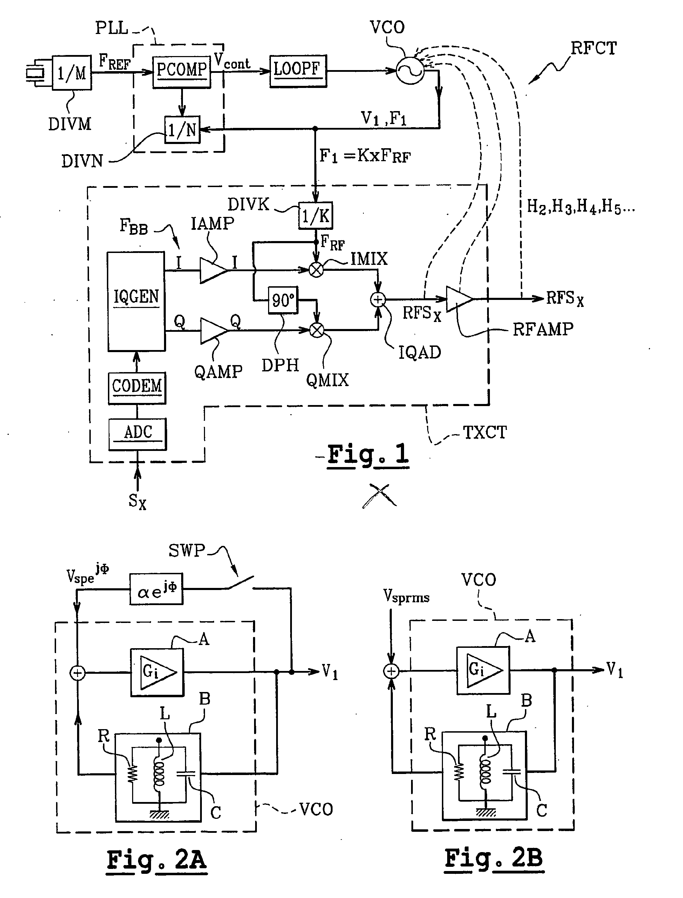

Pour fixer les idées, la figure 1 illustre une application classique d'un VCO dans le domaine de la radiotéléphonie. On distingue sur cette figure un circuit RFCT comprenant un VCO, un circuit formant une boucle à verrouillage de phase ou circuit PLL ("Phase Locked Loop") et un circuit de modulation TXCT.

Le VCO délivre au circuit de modulation TXCT une tension V1 dont la fréquence F1 est contrôlée par le circuit PLL. Le circuit PLL comprend à cet effet un diviseur de fréquence par N DIVN qui reçoit en entrée la tension V1 et qui délivre un signal de fréquence F1/N sur une entrée d'un comparateur de phase PCOMP. Le comparateur de phase reçoit sur une autre entrée une fréquence de référence $F_{REF}$. Cette fréquence $F_{REF}$ est par exemple délivrée par un diviseur par M DIVM dont l'entrée est reliée à un oscillateur à quartz. La sortie du comparateur délivre un signal de contrôle Vcont qui est appliqué sur une entrée de contrôle du VCO par l'intermédiaire d'un filtre de boucle LOOPF ayant une bande passante déterminée: Le signal V1 est ainsi asservi en fréquence et en phase et sa fréquence F1 est égale à $N/M*F_{REF}$.

Le circuit TXCR est ici un circuit de transmission de données par modulation de phase IQ (modulation PM en quadrature) prévu par exemple pour un téléphone mobile.

Le circuit TXCT reçoit en entrée un signal analogique Sx et le signal V1 du VCO, et délivre un signal RFSx destiné à être appliqué à une antenne RF, qui est modulé en phase au moyen de deux signaux I et Q en quadrature.

Le circuit TXCT comprend un diviseur par .K DIVK dont l'entrée reçoit le signal V1 et dont la sortie délivre une porteuse $F_{RF}$ de modulation PM, $F_{RF}$ étant égale à F1/K, K étant généralement égal à 2 ou à 4. Le signal Sx est numérisé par un convertisseur ADC, puis est appliqué à un modem codeur CODEM puis est encore appliqué à un processeur IQGED1. Le processeur IQGEN délivre, dans une bande de base de fréquence $F_{BB}$, des signaux en phase I et en quadrature Q. Le signal I est appliqué sur une entrée d'un mélangeur IMIX par l'intermédiaire d'un amplificateur IAMP, et le signal Q appliqué sur une entrée d'un mélangeur QMIX par l'intermédiaire d'un amplificateur QMW. Le mélangeur IMIX reçoit sur une autre entrée la porteuse $F_{RF}$ et le mélangeur QMIX reçoit sur une autre entrée la porteuse $F_{RF}$ déphasée de 90°, délivrée par un déphaseur DPH. Les sorties des mélangeurs IMIX, QMIX sont appliquées à un additionneur IQAD qui délivre le signal modulé RFSx. Le signal RFSx est appliqué à un amplificateur de sortie RFAMP dont la sortie forme la sortie du circuit de transmission TXCR.

Le signal Sx contient généralement des données à transmettre, par exemple une voix codée, et présente un spectre de fréquences représentatif du schéma de modulation prévu par la norme mise en oeuvre (par exemple GMSK en GSM). En considérant à titre d'exemple que le signal Sx est une tonalité unique ("single tone"), le circuit IQGEN délivre alors deux sinusoïdes pures en quadrature I=cos ($F_{BB}$) et Q=sin ($F_{BB}$). Le résultat de la modulation de phase IQ est dans ce cas une tonalité unique de fréquence $F_{RF}+F_{BB}$ dont la composante image $F_{RF}-F_{BB}$ est supprimée par la modulation en quadrature, et dont la porteuse $F_{RF}$ est également supprimée.

En raison d'imperfections dans le circuit de modulation, ou "non-linéarités", le signal de sortie comprend en plus de la composante utile H1 de fréquence $F_{RF}+F_{BB}$, des harmoniques H2, H3, H4,.... Parmi ces composantes, l'une au moins est proche de la fréquence d'oscillation F1 du VCO. Il s'agit de la première harmonique H1 (composante utile) lorsque le diviseur DIVK n'existe pas ou présente une valeur de division égale à 1 (K=1), de la deuxième harmonique H2 lorsque le diviseur DIVK est un diviseur par deux (K=2) ou de la quatrième harmonique H4 lorsque le diviseur DIVK est un diviseur par quatre (K=4) . Quand K=2, la fréquence de la deuxième harmonique H2 est en effet égale à $2F_{RF}+2F_{BB}$ (soit F1 + $2F_{BB}$) et est très proche de la fréquence centrale F1 du VCO car la fréquence de la bande de base $F_{BB}$ est faible devant la porteuse $F_{RF}$, généralement de l'ordre de quelques GigaHertz. De même, quand K=4, la quatrième harmonique H4 présente une fréquence de $4_{RF}+4F_{BB}$ (soit F1 + $4F_{BB}$) qui est proche de la fréquence centrale du VCO.

Il est connu que l'injection involontaire de cette composante harmonique dans le coeur du VCO, par divers chemins parasites, dégrade les performances du VCO.

Diverses méthodes sont connues pour pallier cet inconvénient.

Il est ainsi connu de réaliser le VCO sur un substrat distinct de celui portant le circuit TXCT de modulation de phase IQ. Ce substrat est agencé dans un coffret blindé et comporte des moyens de connexion au circuit TXCT qui sont équipés de barrières d'isolement empêchant les harmoniques parasites émises par le circuit TXCT de "remonter" jusqu'au coeur du VCO. De telles barrières comprennent généralement des filtres, des connecteurs de type "balun", des isolateurs, des circuits tampons... et doivent être prévues dans tous les chemins de conduction reliant le VCO au circuit TXCT, y compris les chemins d'alimentation. Cette solution est toutefois complexe à mettre en oeuvre et grève le prix de revient des circuits RF, ce qui se répercute en bout de chaîne sur le prix de vente des téléphones mobiles.

D'autres méthodes reposent dans la prévision d'une architecture de circuit de modulation de phase IQ dans laquelle le VCO est peu sensible aux harmoniques parasites.

Ainsi, les systèmes hétérodynes utilisent plusieurs VCO et plusieurs mélangeurs en cascade, et un étage de prémodulation utilisant une fréquence intermédiaire IF. Dans l'étage de sortie, la fréquence du signal modulé est nettement décalée relativement à la fréquence propre du VCO, et les harmoniques susceptibles d'interférer avec le VCO sont des harmoniques et/ou des produits de mélange de haut rang qui sont fortement atténués.

Les systèmes hétérodynes présentent toutefois l'inconvénient de nécessiter l'emploi d'au moins deux VCO; ainsi que des mélangeurs et des filtres supplémentaires, et sont de ce fait eux-mêmes coûteux et encombrants.

Une autre solution pour contrer l'effet d'accrochage en fréquence consiste à prévoir une boucle de recopie dans les VCO. Une telle boucle de recopie permet d'obtenir des fréquences harmoniques décalées par rapport à la fréquence centrale du VCO, et se trouvant en dehors de sa bande passante (déterminée par le filtre de boucle). Toutefois, cette solution nécessite également l'emploi de plusieurs VCO, généralement de trois VCO au moins.

Diverses architectures de circuits de modulation RF ou de VCO peu sensibles à l'effet d'accrochage en fréquence sont décrites notamment dans les brevets US 63211074, US 5144260, US 6281758.

La présente invention vise un procédé tout à fait différent pour supprimer sinon limiter l'effet d'accrochage en fréquence dans les VCO, qui soit simple et peu coûteux à mettre en oeuvre, et qui puisse offrir de bons résultats dans un circuit de modulation n'utilisant qu'un seul VCO, qu'il s'agisse d'un circuit de modulation de phase IQ ou d'un circuit de modulation d'amplitude ou encore d'un circuit de modulation de phase et d'amplitude.

Pour atteindre cet objectif, la présente invention repose sur une étude approfondie des mécanismes de perturbation intervenant dans un VCO, qui sera décrite plus loin. Au terme de cette étude, et comme cela sera vu plus en détail par la suite, on a pu conclure que l'effet d'accrochage en fréquence est imputable à l'injection dans le VCO d'une harmonique parasite qui traverse de multiples chemins parasites ayant chacun leur propre fonction de transfert, formant ainsi une pluralité de signaux parasites. Ces signaux parasites s'additionnent les uns aux autres et il existe un signal parasite résultant unique qui est le résultat de la somme vectorielle des signaux parasites.

On a également pu conclure que le signal parasite résultant est la cause unique de toutes les formes de perturbations attribuables à l'effet d'accrochage en fréquence, et que sa suppression, à tout le moins son atténuation dans les limites du possible, permet de supprimer l'effet d'accrochage en fréquence, à tout le moins de le diminuer d'une manière suffisante au regard des spécifications attendues d'un circuit de modulation RF.

Ainsi, l'idée de la présente invention est d'injecter volontairement dans un VCO un signal parasite qui a la même amplitude que le signal parasite résultant injecté involontairement mais qui se trouve en opposition de phase avec celui-ci, de telle sorte que la somme vectorielle du signal parasite résultant injecté involontairement et du signal parasite injecté volontairement est égale à 0. Un tel signal parasite injecté volontairement forme un signal de compensation selon l'invention qui neutralise l'effet d'accrochage en fréquence dans un VCO.

Une autre idée de la présente invention est de générer le signal de compensation en prélevant l'harmonique perturbatrice dans le circuit de modulation lui-même, en un point riche en harmonique, puis en appliquant cette harmonique à un circuit de contrôle d'amplitude et de phase afin de délivrer le signal de compensation.

Plus particulièrement, la présente invention concerne un procédé pour stabiliser le fonctionnement d'un oscillateur contrôlé en tension piloté par une boucle à verrouillage de phase, l'oscillateur contrôlé en tension délivrant un signal RF et recevant par l'intermédiaire d'au moins un chemin parasite une composante harmonique de fréquence égale ou proche de celle du signal RF émis, susceptible de perturber le fonctionnement de l'oscillateur contrôlé en tension par effet d'accrochage en fréquence, comprenant l'injection, dans l'oscillateur contrôlé en tension, d'un signal de compensation de l'effet d'accrochage en fréquence, dont la phase et l'amplitude sont ajustées de manière à neutraliser les effets perturbateurs de la composante harmonique tel que décrit dans les revendications indépendantes.

Selon un mode de réalisation, le signal de compensation est ajusté en amplitude et en phase de manière à présenter une amplitude sensiblement égale à l'amplitude d'un signal parasite résultant de l'injection involontaire dans l'oscillateur contrôlé en tension, par au moins un chemin parasite, de la composante harmonique perturbatrice, et une phase opposée à celle du signal parasite.

Selon un mode de réalisation, le procédé comprend l'injection non symétrique, en un point de l'oscillateur contrôlé en tension, d'un signal de compensation ayant une composante unique.

Selon un mode de réalisation, le procédé comprend l'injection d'un signal de compensation ayant deux composantes, et l'injection non symétrique de ces composantes en deux points différents de l'oscillateur contrôlé en tension.

Selon un mode de réalisation, le procédé comprend l'injection d'un signal de compensation ayant deux composantes en opposition de phase, et l'injection de ces deux composantes en deux points différents de l'oscillateur contrôlé en tension.

Selon un mode de réalisation, le signal de compensation est généré à partir d'au moins une composante harmonique prélevée dans le circuit de modulation.

Selon un mode de réalisation, le signal de compensation est généré à partir d'au moins une composante harmonique prélevée dans un amplificateur d'un circuit de modulation d'où est émise la composante harmonique perturbatrice.

Selon un mode de réalisation, le signal de compensation est généré à partir d'une composante harmonique produite par un circuit de génération d'harmonique.

Selon un mode de réalisation, la phase du signal de compensation est ajustée au moyen d'un circuit déphaseur.

Selon un mode de réalisation, l'amplitude du signal de compensation est ajustée au moyen d'un circuit atténuateur comprenant des résistances ou des capacités ajustables ou une combinaison de ces éléments.

Selon un mode de réalisation, l'amplitude et la phase du signal de compensation sont ajustées au moyen d'un, groupe d'au moins deux circuits atténuateurs dont les sorties sont additionnées.

Selon un mode de réalisation, l'amplitude et la phase du signal de compensation sont ajustées au moyen d'un groupe de circuits atténuateurs ayant leurs sorties additionnées et recevant en entrée des signaux en quadrature de phase issus de la composante harmonique perturbatrice.

Selon un mode de réalisation, l'amplitude et la phase du signal de compensation sont ajustées au moyen d'un groupe de circuits atténuateurs ayant leurs sorties additionnées et recevant en entrée des signaux en quadrature de phase et des signaux en opposition de phase issus de la composante harmonique perturbatrice.

Selon un mode de réalisation, les signaux en quadrature de phase et en opposition de phase sont générés au moyen d'un circuit déphaseur comprenant un pont équilibré de résistances et de capacités qui est peu sensible à la température.

Selon un mode de réalisation, un circuit atténuateur comprend des capacités ajustables électriquement ou des résistances ajustables électriquement qui-sont ajustées par des signaux analogiques issus de données numériques d'ajustage.

Selon un mode de réalisation, les données numériques d'ajustage sont stockées dans des cellules mémoire.

Selon un mode de réalisation, le signal de compensation est injecté sur une borne d'un composant actif de l'oscillateur contrôlé en tension.

Selon un mode de réalisation, le signal de compensation est injecté sur une borne d'un composant passif de l'oscillateur contrôlé en tension.

Selon un mode de réalisation, le signal de compensation est injecté par couplage inductif.

La présente invention concerne également un circuit RF comprenant un oscillateur contrôlé en tension délivrant un signal RF, une boucle à verrouillage de phase pour contrôler l'oscillateur contrôlé en tension, un circuit de modulation recevant le signal RF et délivrant un signal modulé comprenant au moins une composante harmonique de fréquence égale ou proche de celle du signal RF délivré par l'oscillateur contrôlé en tension, la composante harmonique étant susceptible de perturber le fonctionnement de l'oscillateur contrôlé en tension par effet d'accrochage en fréquence, le circuit RF comprenant un circuit de compensation de l'effet d'accrochage en fréquence comprenant une entrée recevant au moins la composante harmonique perturbatrice et des moyens pour modifier la phase et l'amplitude de la composante harmonique afin de délivrer un signal de compensation de l'effet d'accrochage en fréquence, et des moyens d'injection du signal de compensation dans l'oscillateur contrôlé en tension.

Selon un mode de réalisation, le circuit de compensation est ajusté en amplitude et en phase de manière que le signal de compensation injecté dans l'oscillateur contrôlé en tension présente une amplitude sensiblement égale à l'amplitude d'un signal parasite résultant de l'injection involontaire dans l'oscillateur contrôlé en tension, par au moins un chemin parasite, de la composante harmonique perturbatrice, et une phase opposée à celle du signal parasite.

Selon un mode de réalisation; le circuit de compensation est un circuit non symétrique qui délivre un signal de compensation ayant une composante unique qui est injectée en un point de l'oscillateur contrôlé en tension.

Selon un mode de réalisation, le circuit de compensation est un circuit non symétrique qui délivre un signal de compensation ayant deux composantes qui sont injectées en deux points différents de l'oscillateur contrôlé en tension.

Selon un mode de réalisation, le circuit de compensation est un circuit symétrique qui délivre un signal de compensation ayant deux composantes en opposition de phase qui sont injectées en deux points différents de l'oscillateur contrôlé en tension.

Selon un mode de réalisation, le circuit de compensation reçoit en entrée une composante harmonique prélevée dans le circuit de modulation.

Selon un mode de réalisation, le circuit de compensation reçoit en entrée une composante harmonique prélevée dans un amplificateur de sortie du circuit de modulation.

Selon un mode de réalisation, le circuit de compensation reçoit en entrée une composante harmonique délivrée par un circuit de génération d'harmonique distinct du circuit de modulation.

Selon un mode de réalisation, le circuit de compensation comprend un circuit déphaseur pour modifier la phase de la composante harmonique reçue en entrée.

Selon un mode de réalisation, le circuit de compensation comprend un circuit déphaseur recevant la composante harmonique perturbatrice et délivrant deux signaux en quadrature de phase.

Selon un mode de réalisation, le circuit de compensation comprend un circuit déphaseur recevant la composante harmonique perturbatrice et délivrant des signaux en quadrature et en opposition de phase.

Selon un mode de réalisation, le circuit déphaseur comprend un pont équilibré de résistances et de capacités qui est peu sensible à la température.

Selon un mode de réalisation, le circuit de compensation comprend au moins un circuit atténuateur pour modifier l'amplitude de la composante harmonique reçue en entrée.

Selon un mode de réalisation, le circuit atténuateur comprend des résistances ou des capacités ajustables ou une combinaison de ces éléments.

Selon un mode de réalisation, le circuit RF comprend un groupe d'au moins deux circuits atténuateurs dont les sorties sont additionnées pour contrôler la phase et l'amplitude du signal de compensation.

Selon un mode de réalisation, le circuit RF comprend un groupe de circuits atténuateurs ayant leurs sorties additionnées et recevant en entrée des signaux en quadrature de phase issus de la composante harmonique perturbatrice.

Selon un mode de réalisation, le circuit RF comprend un groupe de circuits atténuateurs ayant leurs sorties additionnées et recevant en entrée des signaux en quadrature de phase et des signaux en opposition de phase issus de la composante harmonique perturbatrice.

Selon un mode de réalisation, un circuit atténuateur comprend des capacités ajustables électriquement ou des résistances ajustables électriquement, qui sont ajustées par des signaux analogiques délivrés par un convertisseur numérique/analogique.

Selon un mode de réalisation, des données numériques d'ajustage des capacités du circuit atténuateur sont stockées dans des cellules mémoire et sont appliquées au convertisseur rnunérique/analogique..

Selon un mode de réalisation, le signal de compensation est injecté sur une borne d'un composant actif de l'oscillateur contrôlé en tension.

Selon un mode de réalisation, le signal de compensation est injecté sur une borne d'un composant passif de l'oscillateur contrôlé en tension.

Selon un mode de réalisation, les moyens d'injection du signal de compensation comprennent une inductance d'injection couplée à une inductance de l'oscillateur contrôlé en tension.

Ces objets, caractéristiques et avantages ainsi que d'autres de la présente invention seront exposés plus en détail dans la description suivante du procédé de l'invention et de divers exemples de réalisation de circuits de compensation selon l'invention, faite à titre non limitatif en relation avec les figures jointes parmi lesquelles :

- la figure 1 représente un circuit de modulation de phase IQ classique comprenant un oscillateur contrôlé en tension,
- la figure 2A est le schéma d'un modèle théorique d'oscillateur contrôlé en tension utilisé pour analyser un phénomène de saut de fréquence,
- la figure 2B est le schéma d'un modèle théorique d'oscillateur contrôlé en tension utilisé pour analyser un phénomène de bruit et de signal parasite,
- la figure 3 représente des sauts de fréquence apparaissant dans un oscillateur contrôlé en tension en présence d'un signal parasite commuté,
- la figure 4 représente l'ampleur des sauts de fréquence en fonction de la phase du signal parasite arrivant dans le coeur du VCO,
- la figure 5A représente le spectre de fréquences d'un signal délivré par le circuit de modulation de phase IQ de la figure 1 lorsqu'un signal sinusoïdal en quadrature lui est appliqué en entrée,
- la figure 5B représente le spectre de fréquences d'un signal présent dans l'oscillateur contrôlé en tension de la figure 1,
- les figures 6A et 6B sont des représentations vectorielles illustrant schématiquement l'apparition d'une fréquence image dans le spectre de fréquences représenté en figure 5B,
- la figure 7 représente une courbe de réjection d'un signal parasite présent dans l'oscillateur contrôlé en tension de la figure 1,
- la figure 8 représente schématiquement un oscillateur contrôlé en tension comprenant un circuit de compensation selon l'invention,
- la figure 9 est le schéma électrique partiel d'un oscillateur contrôlé en tension classique, sur lequel sont repérés des points d'injection d'un signal de compensation selon l'invention,
- la figure 10 représente sous forme de blocs un premier mode de réalisation d'un circuit de compensation selon l'invention,
- la figure 11 est le schéma électrique d'un élément de contrôle de phase représenté sous forme de bloc en figure 10,
- la figure 12 est le schéma électrique d'un élément de contrôle d'amplitude représenté sous forme de bloc en figure 10,
- la figure 13 représente sous forme de blocs un second mode de réalisation d'un circuit de compensation selon l'invention,
- la figure 14 est le schéma électrique d'un générateur de signaux en quadrature représenté sous forme de bloc en figure 13,
- la figure 15 est le schéma électrique d'un élément de contrôle d'amplitude représenté sous forme de bloc en figure 13,
- la figure 16 est un diagramme de phase illustrant le fonctionnement du circuit de compensation de la figure 13,
- la figure 17 représente sous forme de blocs un troisième mode de réalisation d'un circuit de compensation selon l'invention,
- la figure 18 est le schéma électrique d'un générateur de signaux en quadrature représenté sous forme de bloc en figure 17, et
- la figure 19 est le schéma électrique d'un élément de contrôle d'amplitude représenté sous forme de bloc en figure 17.

**Fondements expérimentaux et théoriques de l'invention**

Comme exposé plus haut, l'idée de la présente invention est d'injecter dans un VCO un signal de compensation qui neutralise en phase et en amplitude un signal parasite résultant égal à la somme vectorielle des signaux parasites incidents issus d'une composante harmonique délivrée par un circuit de modulation.

Avant de décrire des exemples de réalisation de circuits de compensation permettant de générer un tel signal de compensation, on va succinctement décrire diverses observations expérimentales, études théoriques et hypothèses ayant conduits à la présente invention.

Les dégradations causées par l'effet d'accrochage en fréquence se traduisent par deux phénomènes distincts. On distingue d'une part des sauts de fréquence instantanés dans le VCO, et d'autre part une modulation parasite entraînant une erreur de phase importante et des raies parasites dans le spectre de fréquences du VCO. Il convient de démontrer que ces deux phénomènes ont une cause unique prenant la forme d'un signal parasite unique ayant une amplitude et une phase déterminées, et qu'ils sont mutuellement corrélés, en terme de phase et d'amplitude du signal parasite qui les engendre.

Des observations expérimentales de ces deux phénomènes ont été combinées avec des études théoriques et des simulations informatiques.

Dans la description qui suit, on se référera à l'exemple de circuit de modulation TXCT décrit en relation avec la figure 1. Le coefficient K du diviseur DIVK est supposé égal à 2. Dans ce cas, c'est la deuxième harmonique H2 du signal de sortie de l'amplificateur RFKMP qui est la composante la plus proche de la fréquence centrale du VCO.

Modélisation d'un VCO

Conformément à une théorie admise et comme illustré sur les figures 2A, 2B, un VCO peut être modélisé sous forme de deux éléments A et B en boucle fermée, A étant la partie active du VCO, modélisée par un amplificateur de transconductance de gain Gi, B étant la partie réactive du VCO, modélisée par une résistance, une capacité et une inductance en parallèle, soit une impédance F ($\omega$) de valeur :

$$(1) \quad F (\omega) = (1/R + 1/ (j \omega L) + j \omega C)^{-1}$$

A l'équilibre du VCO (commutateur SWP ouvert en figure 2A), l'équation de la boucle fermée s'écrit :

$$(2) \quad V1 = V1 \, Gi \, F (\omega)$$

soit :

$$(3) \quad Gi = 1/F (\omega)$$

Pour que des conditions d'oscillation stable soient obtenues, il faut que la fréquence centrale $\omega 1$ du VCO soit égale à :

$$(4)\quad \omega1 = 1/\sqrt{LC}$$

Il en découle que : Gi = 1/R

<u>Premier phénomène perturbateur : sauts de fréquence dans le VCO</u>

Un premier phénomène de dégradation des performances du VCO en présence d'un signal parasite est un décalage de la fréquence centrale F1 du VCO. Ce signal parasite apparaît quand les divers éléments du circuit de modulation sont activés, ce qui est schématisé en figure 2A par la fermeture d'un interrupteur SWP. La fréquence centrale F1 est alors décalée vers une fréquence F2 de pulsation ω2 et le décalage de fréquence ΔF peut s'écrire :

$$(5)\quad \Delta F = (\omega2 - \omega1)/2\pi$$

Lorsque le VCO est associé à un circuit PLL, comme illustré en figure 1, le décalage de fréquence est compensé par le circuit PLL qui ramène le VCO sur sa fréquence centrale originelle. Le décalage en fréquence se traduit alors par des sauts de fréquence instantanés ΔF (t).
Ce phénomène a été observé en appliquant aux circuits mélangeurs IMIX et QMIX des impulsions de tension. La fréquence .FBB de la bande de base est alors nulle et l'harmonique H2 du signal RFSx est égale à la fréquence propre F1 du VCO :

$$(6)\quad K=2 \text{ et } F_{BB}=0 \implies H2 = 2F_{RF} + 2*0 \implies H2 = 2F_{RF} = F1$$

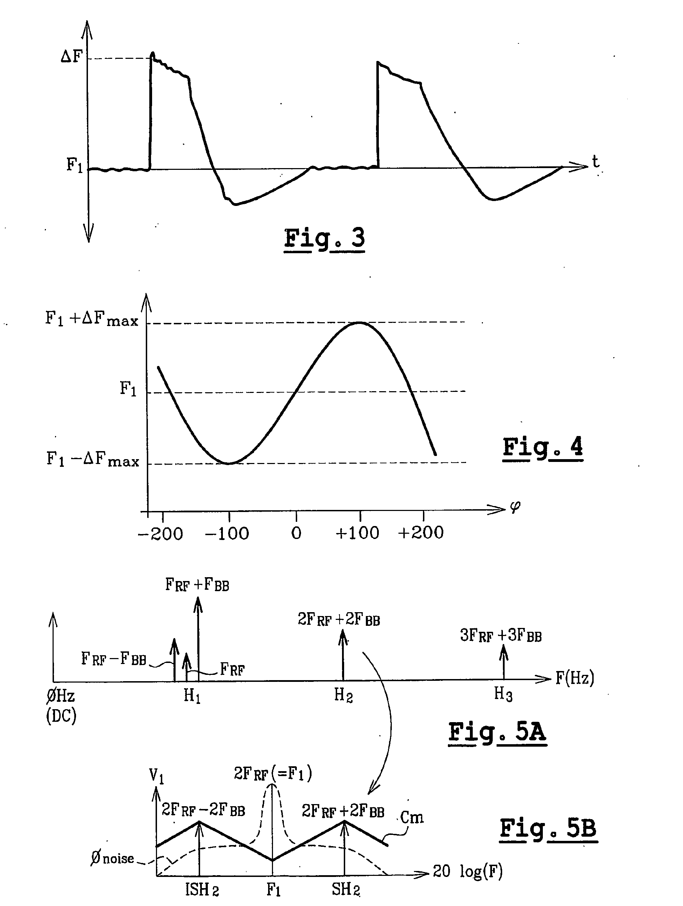

Comme illustré en figure 3, on observe alors que la tension V1 délivrée par le VCO présente des sauts, de fréquence à chaque impulsion émise sur les canaux IQ. Les sauts de fréquence sont dus à l'activation instantanée des chemins parasites et le rétablissement lent de la fréquence d'origine par action de la boucle à verrouillage de phase. L'amplitude' des tensions appliquées aux canaux I et Q détermine la phase et l'amplitude du signal de sortie RFSx et donc de l'harmonique perturbatrice H2 réinjectée dans le VCO.
Les sauts de fréquence peuvent être caractérisés mathématiquement en référence au modèle de VCO décrit plus haut et représenté en figure 2A. En considérant que le signal parasite a pour expression Vsp*$e^{j\varphi}$ et présente une amplitude Vsp et une phase $\varphi$, l'équation de boucle est la suivante :

$$(7)\quad V1 = V1 \, Gi \, F(\omega) + Vsp \, e^{j\varphi}$$

En considérant maintenant que le signal parasite est la tension de sortie V1 du VCO qui est réinjectée dans le coeur du VCO par un chemin parasite ayant une fonction de transfert $\alpha \, e^{j\varphi}$, lorsque le commutateur SWP est fermé, l'équation de boucle peut s'écrire ainsi :

$$(8)\quad V1 = V1 \, Gi \, F(\omega) + V1 \, \alpha \, e^{j\varphi}$$

avec :

$$(9)\quad \alpha = Vsp/V1$$

En exprimant la fonction de transfert parasite en coordonnées cartésiennes :

$$(10) \quad b = \text{Re} \; (\alpha \; e^{j\varphi})$$

$$(11) \quad d = \text{Im} \; (\alpha \; e^{j\varphi})$$

on peut trouver le terme $\omega 2$ qui satisfait l'équation de boucle :

$$(12) \quad \omega 2 = 1/2 \; [d/ \; (1-b)RC + \sqrt{[d/ \; (1-b)RC)^2 + 4/LC]} \; ]$$

Ainsi, il apparaît que le terme "d" est nul et que la pulsation $\omega 2$ est égale à $\omega 1$ si la phase du signal réinjecté est nulle par rapport à la phase de la tension V1 ($\varphi=0$). Dans ce cas le saut de fréquence $\Delta F$ est nul. Si au contraire $\varphi$ = 90° (phase maximale du signal parasite) alors b=0, d=$\alpha$ et :

$$(13) \quad \omega 2 = 1/2 \; [\alpha/RC + \sqrt{[\; (\alpha/RC)^2 + 4/LC]}$$

soit :

$$(14) \quad \Delta F = [1/2 \; [\alpha/RC + \sqrt{[(\alpha/RC)^2 + 4/LC]} \; - \; \omega 1]/2\pi$$

Ces relations entre la phase du signal perturbateur ont été confirmées par des simulations informatiques faites à partir du modèle de VCO. En simulant l'injection dans le VCO d'un signal parasite de phase variable, on a pu tracer une courbe telle que celle représentée en figure 4. Il apparaît sur cette figure que la fréquence centrale F1 du VCO présente des décalages variant entre deux maxima $+\Delta F$max et $-\Delta F$max en fonction de la phase $\varphi$ du signal parasite, et présente une valeur nulle lorsque la phase du signal parasite est nulle.

En définitive, les équations permettant de caractériser les sauts de fréquence sont confirmées par les constatations expérimentales ainsi que par les simulations informatiques. On sait donc en ce qui concerne les sauts de fréquence qu'il existe une correspondance exacte entre les caractéristiques électriques (amplitude et phase) du signal parasite qui entre dans le coeur du VCO et le phénomène perturbateur.

Second phénomène perturbateur : raies parasites dans le spectre de fréquences du VCO

Ce phénomène est mis en évidence en appliquant par exemple sur le canal I et le canal Q deux sinusoïdes pures..de fréquence $F_{HB}$ en quadrature de phase. Comme représenté en figure 5A, il apparaît alors à la sortie du circuit TXCT un signal H1 à bande latérale unique, de fréquence $F_{RF}+F_{HB}$ (composante H1) . Il apparaît également des harmoniques H2, H3... On distingue également des traces de la porteuse $F_{RF}$ et des traces du signal image $F_{RF}-F_{HB}$ qui est neutralisé ou au moins affaibli par la modulation de phase en quadrature.

K étant ici égal à 2, l'harmonique H2 est la composante du signal modulé qui est la plus proche de la fréquence centrale F1 du VCO. Cette harmonique de fréquence $2_{FR}+2F_{BB}$, soit $F1+2F_{BB}$, est réinjectée dans le VCO par des chemins parasites. En observant la sortie du VCO au moyen d'un analyseur de spectre, on voit apparaître, en sus du signal V1 de fréquence FI, une raie parasite SH2 de même fréquence que l'harmonique H2, comme cela est illustré en figure 5B.

On voit également apparaître, à gauche de la fréquence centrale F1 du VCO, une raie parasite image ISH2 de fréquence $2F_{RF}-2F_{BB}$ (soit $F1+2F_{BB}$).

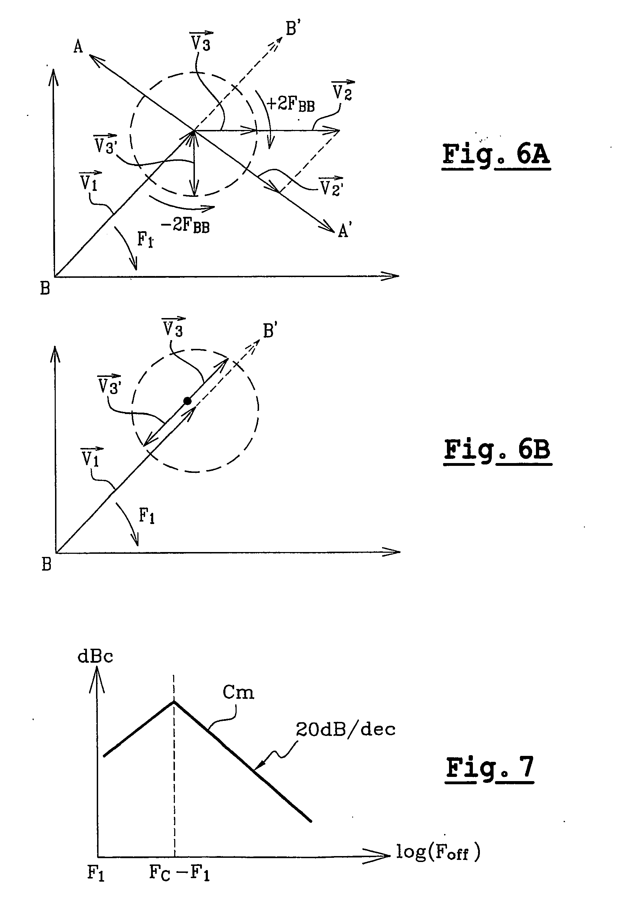

La présence de cette raie ISH2 peut s'expliquer d'une manière illustrée sur les figures 6A et 6B. Un VCO est un système qui, par conception, est limité en amplitude et fonctionne comme un amplificateur à écrêtage vis-à-vis du signal parasite. Or, le signal parasite injecté, de fréquence $F1+2F_{BB}$, est la somme vectorielle d'un vecteur $\uparrow$V1 de

fréquence F1 et d'un vecteur tournant ("phasor") ↑V2 de fréquence $2F_{BB}$. L'amplitude du vecteur ↑V1 est définie par les conditions d'oscillation du VCO et ne peut pas être dépassée. Ainsi, la composante d'amplitude du vecteur tournant ↑V2 de fréquence $2F_{BB}$ est supprimée par le VCO. Comme représenté en figure 6A, le mécanisme de suppression de la composante d'amplitude transforme le vecteur ↑V2 en un vecteur ↑V2' orienté selon un axe AA' qui est perpendiculaire à un axe BB' selon lequel le vecteur ↑V1 est orienté. La décomposition vectorielle de ce vecteur ↑V2' donne deux vecteurs ↑V3, ↑V3' d'amplitude V2/2 en opposition de phase et de fréquences respectives $2F_{BB}$ et $-2F_{BB}$ A cela s'ajoute un autre phénomène dû à la présence du circuit PLL, qui contraint le vecteur parasite ↑V1+↑V3+↑V3' à être en phase avec le vecteur central. ↑V1 du VCO. Ainsi, comme illustré en figure 6B, la phase du vecteur résultant de la somme des deux vecteurs ↑V3 , ↑V3.' est maintenue constante et égale à celle du vecteur central ↑V1. Elle est donc alignée avec l'axe tournant BB'. Ce phénomène se produit dans bande passante de la boucle à verrouillage de phase.

En résumé, l'existence de la raie image ISH2 est due aux contraintes d'amplitude et aux contraintes de phase qui s'exercent sur le signal de modulation parasite une fois que celui-ci est injecté dans le VCO.

Ces perturbations sont également représentées sur la figure 5B, sur laquelle on a tracé d'une part une courbe Φnoise représentant le bruit de phase engendrée par l'agitation thermique dans la résistance du VCO, et d'autre part une courbe Cm décrite plus loin représentant les variations de l'amplitude de chaque raie parasite lorsque la fréquence $F_{BB}$ varie.

Dans des conditions d'utilisation réelle, les signaux I et Q dans la bande de base ne sont pas des sinusoïdes pures mais des signaux numériques complexes dont la fréquence instantanée varie en permanence à l'intérieur de la bande de base. En conséquence, les deux raies parasites représentées en figure 5B bougent sans cesse et l'on observe tout un spectre de signaux parasites.

L'amplitude des deux raies parasites a été mesurée expérimentalement pour diverses valeurs de la fréquence $F_{BB}$ des signaux I et Q. La courbe Cm représentée sur la figure 5B est représentée plus en détail en figure 7, et est tracée ici pour une seule raie parasite SH2, ISH2. L'axe horizontal du tracé représente le logarithme d'une fréquence offset Foff égale à la différence entre la fréquence $2F_{BB}$ de la raie parasite et la fréquence centrale F1 du VCO. L'axe vertical est l'amplitude des raies parasites en dBc. Ce tracé expérimental montre que l'amplitude des raies parasite SH2, ISH2 présente un maximum lorsque la fréquence $2F_{BB}$ tombe sur la fréquence de résonance Fc de la boucle PLL (qui correspond à la fréquence de coupure du filtre de boucle LOOPF telle que modifiée par le gain de boucle). Lorsque la fréquence $2F_{BB}$ augmente au-delà de la fréquence Fc, l'amplitude des raies parasites décroît avec une pente de 20db/décade. La courbe Cm décroît également rapidement à l'intérieur de la bande passante du circuit PLL, car le signal parasite est rejeté par le gain de boucle.

Il est important de noter que ces observations confirment qu'il est suffisant de neutraliser les effets perturbateurs de l'harmonique la plus proche de la fréquence centrale F1 du VCO, dont la fréquence se trouve au voisinage des limites de la bande passante du VCO, car l'effet perturbateur des harmoniques de rang supérieur est faible en raison de l'atténuation de 20 dB par décade.

On peut également noter que l'amplitude des harmoniques diminue rapidement en allant vers les harmoniques de rang élevé. Ainsi, en pratique, les circuits de modulation radiofréquence les plus sensibles à l'effet d'accrochage en fréquence sont les circuits dans lesquels , K=2, par exemple les circuits de transmission prévus pour le réseau DCS (Digital Cellular System). Les circuits de transmission pour le réseau GSM ("Global System for Mobile Communication") présentent un rapport K généralement égal à 4 et leurs oscillateurs contrôlés en tension sont moins sensibles à l'influence de l'harmonique de rang 4, qui demeure toutefois gênante.

Le bruit de phase observé sur la figure 5B peut être caractérisé de façon théorique en se référant au schéma de la figure 2B. Selon une théorie admise, le bruit de phase naturel d'un VCO, en l'absence de signal parasite extérieur, est engendré par l'agitation thermique de la résistance R du VCO (partie réactive F (ω)). Le bruit de phase naturel exprimé en dBc/Hz (ratio bruit/ signal de porteuse en décibels, soit ici un ratio bruit/amplitude de la fréquence centrale du VCO) obéit à la relation suivante :

$$(15) \quad \Phi_{out}(\omega) =$$

$$20\log[(1/\sqrt{2}) * (\sqrt{(4kTR)}/V1rms)/(1-F(\omega)/R)] \; dBc/Hz$$

"V1rms" étant l'amplitude d'oscillation (en Volt rms) du VCO en l'absence de signal parasite, k étant la constante de Boltzmann, T la température en Kelvin, et R la résistance de la partie réactive F (ω) exprimée en Ohms.

En d'autres termes, le bruit de phase apparaît comme le rapport entre l'amplitude du bruit thermique et l'amplitude V1rms de la fréquence centrale du VCO vu à travers la fonction de transfert F (o) .

En considérant que la source de bruit est un parasite injecté dans le VCO, et en désignant par. "Vsprms" son amplitude efficace (en Volt rms), un raisonnement similaire permet de montrer que le bruit de phase Φout dû à l'injection de la tension parasite (et qui est donc plutôt maintenant un niveau de raie parasite) obéit à la relation suivante :

$$(16)\ \ \Phi \mathrm{out}(\omega \mathrm{off})=\ 20\ \log[1/2*(\mathrm{Vsprms}/\mathrm{V1rms})/(1-(F(\omega \mathrm{off})/R))\ ] \ \mathrm{dBc}$$

ωoff étant la pulsation correspondant à la fréquence offset Foff (Foff = F1-2$F_{BB}$ ou F1+2$F_{BB}$ quand K=2)

La relation 16 confirme le fait que le niveau de raie parasite en fonction de la fréquence offset présente une décroissance linéaire de 20 dB par décade en dehors de la bande passante de la boucle PLL, ce qui a été constaté expérimentalement plus haut (figure 7) .

En renversant la relation 16, on obtient :

$$(17)\ \ \mathrm{Vsp}(\Phi \mathrm{out})\ =\ 2\ 10^{\Phi \mathrm{out}/20}\ |1\ -\ (F\ (\omega)/R)\ |\mathrm{V1}$$

En mesurant le niveau de raie parasite Φout en dBc à la sortie du VCO, on peut donc connaître le niveau du signal parasite (en tension effective) entrant dans le coeur du VCO.

**Conclusions sur les études expérimentales et théoriques et formulation d'un problème technique**

En résumé de ce qui précède, des équations mathématiques confirmées par des observations expérimentales et par des simulations informatiques, montrent que les deux phénomènes perturbateurs que sont les sauts de fréquence et la modulation parasite (ou bruit de phase) sont attribuables à une cause unique prenant la forme d'un signal parasite, d'amplitude et de phase déterminées.

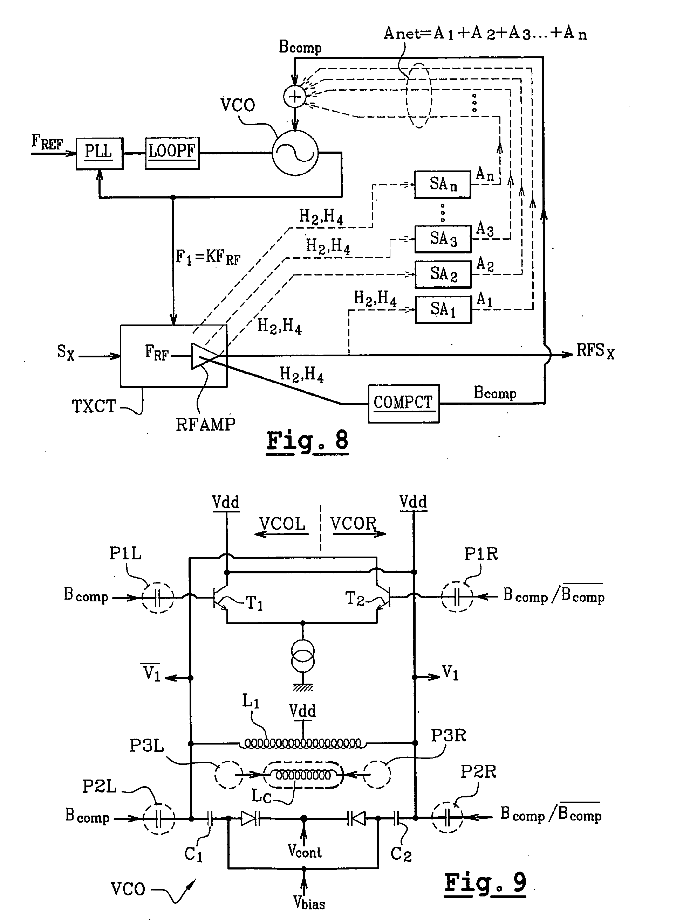

En référence à la figure 8, un modèle de problème technique et un modèle de solution à ce problème technique peuvent ainsi être formulés comme suit : dans le circuit représenté en figure 8, les étages de modulation IQ du circuit de modulation TXCT modulent une porteuse $F_{RF}$ proportionnelle à la fréquence centrale F1 du VCO, et plus particulièrement égale à F1/2 (K=2) ou à F1/4 (K=4) selon les applications. Le signal modulé passe dans un circuit de modulation réalisé avec des composants réels et donc nécessairement imparfaits, et présente ainsi une légère imperfection de non-linéarité. Le signal de sortie délivré par un circuit non linéaire peut être modélisé par un polynôme :

$$(18)\ \ F(t)\ =\ b0\ +\ b1x(t)\ +\ b2x(t)^2\ +\ b3x(t)^3\ +\ b4x(t)^4...$$

soit :

$$(19)\ \ F(t)\ =\ b0\ +\ H1\ +\ H2\ +\ H3\ +\ H4\ +...$$

b0 étant la composante continue (DC offset) du signal de sortie, H1 étant la fondamentale ou partie utile du signal de sortie et b1 le gain sur le signal utile, H2 étant la deuxième harmonique et b2 l'amplitude de la deuxième harmonique, etc..

Des harmoniques sont ainsi générées et une harmonique au moins tombe dans la bande passante du VCO et perturbe son fonctionnement, ce qui correspond à une injection de signal parasite. L'harmonique parasite qui perturbe le plus le VCO est celle qui se trouve le plus près de la fréquence d'oscillation du VCO, soit l'harmonique H2 quand K=2 ou l'harmonique H4 quand K=4,...

L'harmonique parasite se propage jusqu'au coeur du VC0 par de multiples chemins parasites (induction magnétique, radiations électromagnétiques, chemins passant par le substrat, chemins passant par les lignes d'alimentation électrique...) ayant chacun leur propre fonction de transfert, représentés sur la figure 8 par des blocs SA1, SA2, SA3,....SAn.

Quel que soit le nombre de chemins parasites, les signaux parasites A1, A2, A3... An s'additionnent et il existe donc un signal parasite résultant Anet qui est le résultat de la somme vectorielle des vecteurs A1, A2,... An et qui présente une amplitude et une phase déterminées :

$$(20) \quad Anet = A0 \ e^{j\varphi}$$

**Caractéristiques générales du procédé de l'invention**

Selon l'invention, on prévoit ainsi d'injecter dans le VCO un signal parasite formant un signal de compensation Bcomp, ayant la même amplitude que le signal Anet mais en opposition de phase avec le signal Anet (soit un déphasage de 180°), de telle sorte que Anet + Bcomp = 0.

Le signal Bcomp est délivré par un circuit de compensation COMPCT selon l'invention, auquel on applique en entrée un signal déterminé. Le circuit COMPCT assure l'ajustage de la phase et de l'amplitude du signal déterminé qui lui est fourni en entrée, pour obtenir le signal de compensation Bcomp. Divers exemples de réalisation d'un tel circuit seront décrits dans ce qui suit.

Le signal déterminé à fournir au circuit COMPCT doit correspondre en fréquence à l'harmonique H2 ou H4 dont on souhaite neutraliser les effets perturbateurs. Comme cela apparaîtra dans les exemples ci-après, il est avantageux que ce signal soit l'harmonique perturbatrice elle-même, qui est facile à extraire des étages de sortie des circuits de modulation, par exemple certains points de l'amplificateur de sortie RFAMP qui sont riches en harmoniques.

A noter qu'il peut arriver, dans certaines applications, qu'un noeud riche en harmoniques H2 ou H4 ne soit pas disponible ou ne soit pas accessible. On réalisera dans ce cas un circuit générateur d'harmonique, en prélevant dans le circuit TXCT le signal de porteuse RFSx après les étages de modulation (soit le signal $F_{RF}$ modulé) et en appliquant ce signal à des composants non linéaires.

Enfin, on doit également déterminer le point d'injection du signal de compensation dans le VCO. Diverses options peuvent être prévues et l'on se référera à titre d'exemple à la figure 9, qui est le schéma électrique partiel d'un VCO classique. Ce VCO est ici de type symétrique et présente une partie gauche VCOL ("VCO left") et une partie droite VCOR ("VCO right") qui fonctionnent en opposition de phase pour la génération du signal de sortie V1. Divers points P1L, P1R, P2L, P2R, P3L, P3R d'injection du signal de compensation Bcomp sont représentés par des cercles en traits pointillés.

Le signal Bcomp peut être injecté sur des bornes de commande de composants actifs, par exemple sur des bases de transistors bipolaires T1, T2 (points P1L ou P1R) par l'intermédiaire d'un condensateur visant à éviter l'introduction d'un signal continu parasite. Le signal Bcomp peut également être injecté sur des bornes de composants passifs, par exemple sur des cathodes de condensateurs C1, C2 (points P2L, P2R) dont les anodes reçoivent une tension de polarisation Vbias. L'injection du signal Bcomp peut également être assurée par couplage inductif, par exemple au moyen d'une inductance d'injection Lc couplée avec une inductance L1 du VCO. Le signal Bcomp est alors appliqué sur l'une des extrémités de l'inductance Lc (points P3L, P3R) l'autre extrémité étant à la masse.

On décrira maintenant divers exemples de réalisation d'un circuit de compensation selon l'invention. Dans ce qui suit, on supposera comme précédemment que le signal de compensation vise à neutraliser les effets perturbateurs de la deuxième harmonique H2 du signal modulé délivré par le circuit TXCT.

**Exemples de circuits de compensation**

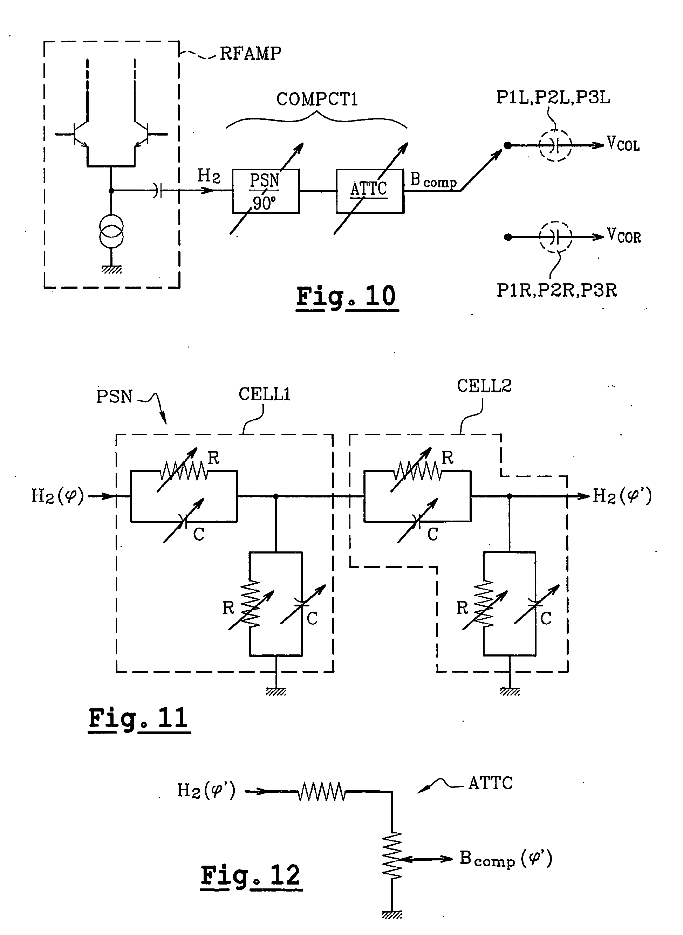

La figure 10 représente un premier mode de réalisation d'un circuit de compensation COMPCT1 selon l'invention. Le circuit COMPCT1 comprend un réseau à décalage de phase PSN recevant en entrée l'harmonique H2. La sortie du circuit PSN est appliquée à un atténuateur d'amplitude ATTC. La sortie de l'atténuateur ATTC délivre le signal Bcomp et est appliquée à la partie VCOL ou à la partie VCOR du VCO, en un point d'injection à choisir par exemple parmi les points d'injection PIL/PIR, P2L/P2R, P3L/P3R décrits plus haut.

L'harmonique H2 est prélevée sur un noeud de l'amplificateur de sortie RFAMP riche en harmoniques et dépourvu de la fondamentale H1 (signal utile), par exemple sur un noeud d'émetteur de deux transistors bipolaires, et par l'intermédiaire d'une capacité visant à supprimer les éventuelles composantes continues du signal présent sur ce noeud.

Comme représenté en figure .11, le circuit PSN comprend une ou deux cellules RC en série, ici deux cellules CELL1, CELL2. Chaque cellule GELL1, CELL2 comprend un premier groupe RC formé par une capacité et une résistance ajustables en parallèle en série avec un second groupe RC formé également par une capacité et une résistance ajustables en parallèle. Le point de sortie de chaque cellule est le point milieu des deux groupes RC. Selon la valeur conférée à ces éléments, le circuit PSN permet d'appliquer l'avance ou le retard de phase souhaité à l'harmonique H2. Ainsi, l'harmonique H2 prélevée avec une phase déterminée φ dans l'amplificateur RFAMP est délivrée par le circuit PSN avec une phase corrigée φ'.

Comme représenté en figure 12, le circuit atténuateur ATTC est par exemple un pont diviseur résistif ajustable, qui corrige l'amplitude de l'harmonique H2 (φ') pour délivrer le signal Bcomp (φ').

Les circuits PSN et ATTC sont ajustés au cours d'une étape de test électrique précédant la mise en service du circuit RFCT. Les valeurs de phase et d'amplitude sont ajustées empiriquement en appliquant des signaux de test au circuit RFCT, jusqu'à ce que la sortie du VCO délivre un signal "propre" dépourvu des phénomènes parasites décrits plus haut, cela bien entendu dans la mesure du possible et dans les limites des tolérances admises, car une neutralisation totale des effets perturbateurs est en pratique peu réaliste.

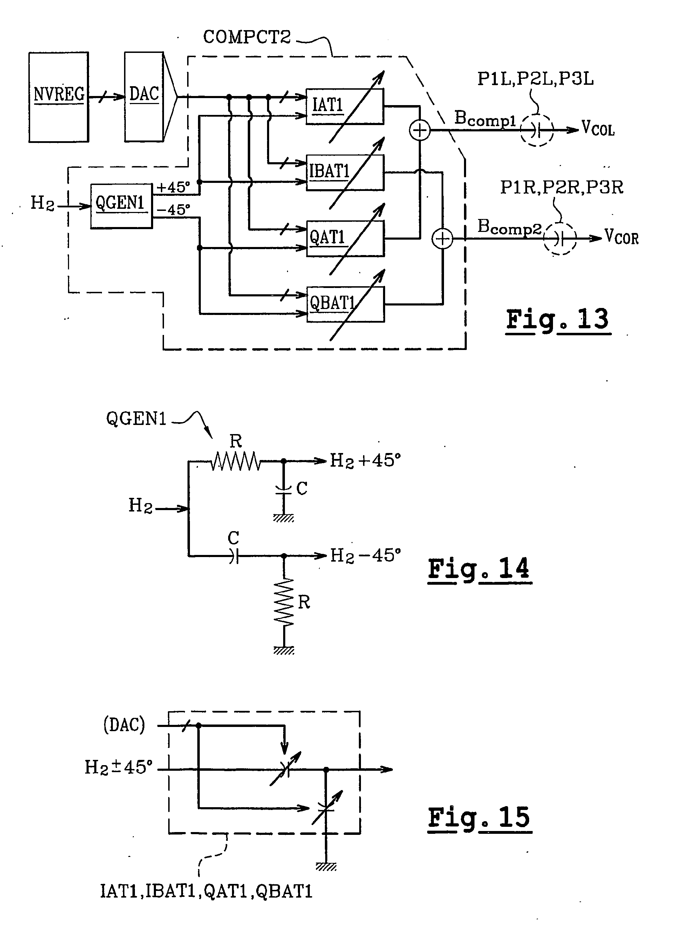

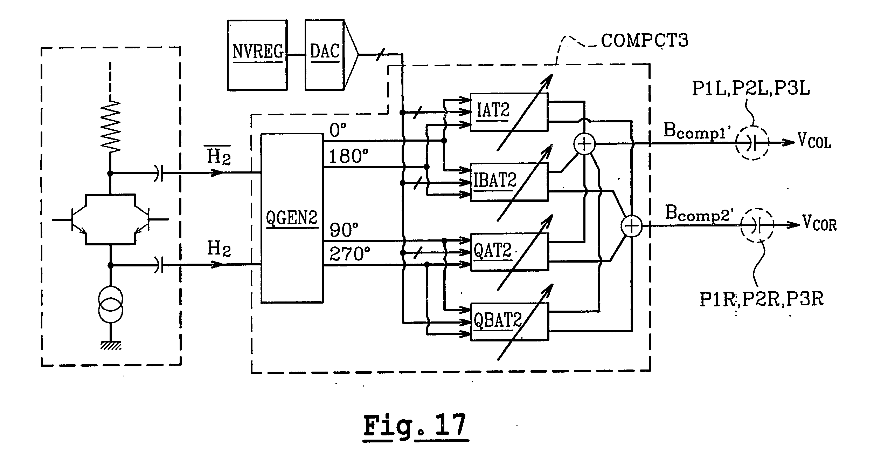

Ce mode de réalisation du circuit de compensation selon l'invention est préférentiellement destiné à être mis en oeuvre sous forme de circuit à composants discrets. On décrira maintenant en se référant aux figures 13 et 17 deux autres modes de réalisation CCMPCT2, COMPCT3 du circuit de compensation selon l'invention qui sont prévus pour être préférentiellement mis en oeuvre dans un circuit intégré RF.

Les circuits de compensation représentés sur ces figures sont ajustables numériquement et les valeurs d'ajustage, une fois déterminées, sont enregistrées dans un registre NVREG. Les sorties du registre NVREG sont appliquées à un convertisseur numérique/analogique. DAC à plusieurs voies, qui délivre une pluralité de signaux analogiques à des capacités ajustables électriquement de type VARICAP.

Le circuit COMPCT2 représenté en figure 13 est du type non symétrique ("single ended") et reçoit en entrée l'harmonique H2, qui est prélevée de la, manière décrite plus haut. Le circuit COMPCr2 comprend un générateur de quadrature QGEN1 et quatre atténuateurs/déphaseurs IAT1, IBAT1, QAT1, QBAT1 pilotés par les sorties du convertisseur DAC. Il s'agit d'atténuateurs purs qui contrôlent quatre signaux sinusoïdaux, respectivement I, IB (ou /I, soit I déphasé de 180°), Q (sinusoïde en quadrature avec I) et QB (ou /Q, soit Q déphasé de 180°). La somme des quatre sinusoïdes donne une nouvelle sinusoïde ayant une amplitude et une phase qui est le résultat de la somme vectorielle des quatre signaux.

Le générateur QGEN1 délivre respectivement, sur deux sorties distinctes, l'harmonique H2 déphasée de +45° et l'harmonique H2 déphasée de -45°. L'harmonique H2 déphasée de +45° est appliquée aux atténuateurs IAT1 et IBAT1 tandis que l'harmonique H2 déphasée de -45° est appliquée aux atténuateurs QAT1 et QBAT1. Les sorties des atténuateurs IAT1 et QAT1 sont additionnées pour former un signal Bcomp1 qui est appliqué à la partie VCOL du VCO, sur l'un des points d'injection P1L, P2L ou P3L décrit plus haut. Les sorties des atténuateurs IBATI et QBAT1 sont additionnées pour former un signal Bcomp2 qui est appliqué à la partie VCOR du VCO, sur l'un des points d'injection P1R, P2R, P3R décrit plus haut.

Comme illustré en figure 14, le générateur de quadrature - QGEN1 comprend par exemple une cellule RC qui déphase l'harmonique H2 de +45° et une cellule CR en parallèle avec la cellule RC, qui déphase l'harmonique H2 de -45°.

Comme illustré en figure 15, chaque atténuateur IAT1, IBAT1, QAT1, QBAT1 comprend un pont diviseur capacitif formé par deux capacités VARICAP pilotées chacune par une sortie du convertisseur DAC, laquelle délivre un signal continu ("DC signal") nécessaire au contrôle de ces éléments. Le système de polarisation des capacités VARICAP est bien connu de l'homme de l'art et ne sera pas décrit ici dans un souci de simplicité.

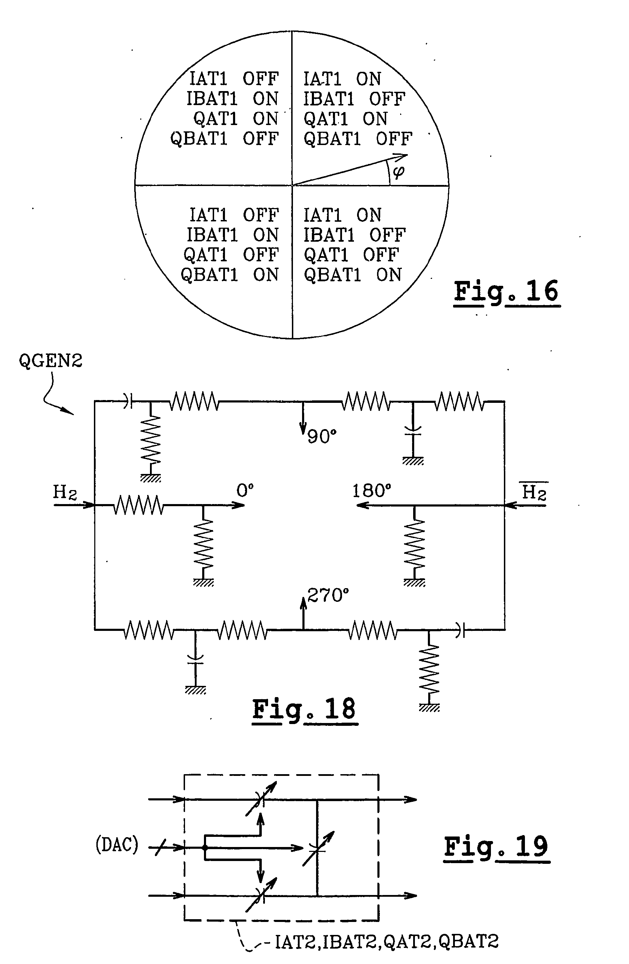

La figure 16 est un diagramme de phase à quatre cadrans illustrant la gamme de correction de phase et d'amplitude offerte par les atténuateurs selon l'invention. Lorsque les atténuateurs IAT1 et QAT1 sont actifs et que les atténuateurs IBAT1, QBAT1 sont désactivés (état haute impédance), la phase du signal Bcomp est ajustable dans les limites du premier cadran, soit entre 0 et 90°, et l'amplitude du signal Bcomp est déterminée par le rapport entre les valeurs des capacités qui forment chaque atténuateur. Lorsque les atténuateurs IBAT1 et QAT1 sont actifs et les atténuateurs IAT1, QBAT1 sont désactivés, la phase du signal Bcomp est ajustable dans les limites du second cadran, soit entre 90° et 180°. Lorsque les atténuateurs IBAT1 et QBAT1 sont actifs et les atténuateurs IAT1, QAT1 sont désactivés, la phase du signal Bcomp est ajustable dans les limites du troisième cadran, soit entre 180° et 270°. Lorsque les atténuateurs IAT1 et QBAT1 sont actifs et les atténuateurs IAT1, QAT1 sont désactivés, la phase du signal Bcomp est ajustable dans les limites du quatrième cadran, soit entre 270° et 0°.

Le circuit COMPCT3 représenté en figure 17 est du type équilibré ("balanced") et reçoit en entrée, outre l'harmonique H2, une harmonique /H2 déphasée de 180°. L'harmonique H2 est prélevée comme décrit plus haut sur un noeud d'émetteur de deux transistors de l'amplificateur RFAMP L'harmonique /H2 est prélevée sur un noeud de collecteur des mêmes transistors.

Le circuit COMPCT3 comprend un générateur de quadrature QGEN2 de type symétrique et quatre atténuateurs déphaseurs IAT2, IBAT2, QAT2, QBAT2 pilotés par le convertisseur DAC, comprenant chacun une première et une deuxième sortie. Le générateur QGEN2 reçoit les harmoniques H2, /H2 et délivre respectivement, sur quatre sorties distinctes, l'harmonique H2 déphasée de 0°, de +90°, de +180° et de +270°. Les harmoniques H2 déphasées de 0° et de 180° sont appliquées toutes deux aux atténuateurs IAT2 et IBAT2. Les harmoniques H2 déphasées de 90° et 270° sont appliquées toutes deux aux atténuateurs QAT2 et QBAT2.

Les premières sorties des atténuateurs IAT2, IBAT2, QAT2, QBAT2 sont additionnées pour former un signal Bcomp1'-qui est appliqué à la partie VCOL du VCO, en un point d'injection P1L, P2L ou P3L. Les deuxièmes sorties des atténuateurs IAT2, IBAT2, QAT2, QBAT2 sont additionnées pour former un signal Bcomp2' en opposition de phase avec Bcomp1', qui est appliqué à la partie VCOL du VCO, en un point d'injection P1R, P2R ou P3R.

Comme illustré en figure 18, le générateur QGEN2 comprend un pont équilibré de capacités et de résistances, dans lequel les variations de température et de procédé (variations des caractéristiques des éléments avec le procédé de fabrication) sont réduites. Ainsi ce générateur assure un décalage de phase relatif de 90° entre chacune de ses sorties, quelle que soit la variation des résistances et des capacités avec la température ou avec le procédé de fabrication, et la fréquence de travail F1.

Le générateur QGEN2 peut aussi être réalisé sous forme de filtre POLYPHASE, afin de réduire encore plus les effets de variation de température, de procédé et de fréquence de travail.

Comme illustré en figure 19, chaque atténuateur IAT1, IRAT1, QAT1, QBAT1 comprend un pont diviseur capacitif symétrique à deux entrées et à deux sorties, formé par trois capacités ajustables VARICAP pilotées chacune par une sortie du convertisseur DAC délivrant une tension de polarisation. Comme précédemment, le contrôle des tensions de polarisation des capacités ajustables VARICAP ne sera pas décrit dans un souci de simplicité. La première capacité ajustable est agencée entre la première entrée et la première sortie. La deuxième capacité ajustable est agencée entre la deuxième entrée et la deuxième sortie. La troisième capacité ajustable est agencée entre les deux sorties.

Le fonctionnement en phase et en amplitude du circuit de compensation COEPoe3 est similaire dans son principe au circuit C%PCT2 décrit plus haut, et offre l'avantage supplémentaire d'être moins sensible aux variations de température et de procédé, et d'être plus précis.

Il.apparaîtra clairement à l'homme de l'art que la présente invention est susceptible de diverses autres variantes et modes de réalisation comme la génération de quadrature active, l'utilisation de filtre POLYPHASE... Egalement, des résistances ajustables électriquement peuvent être utilisées à la place des capacités VARICAP.

Bien que l'on se soit attaché dans ce qui précède à décrire un circuit de compensation des effets perturbateurs d'une harmonique de deuxième ou de quatrième rang, il va de soi que le champ d'application de la présente invention n'est pas limité à ces exemples, K pouvant être égal à 1 (fréquence du VCO égale à la fréquence RF), à 4, etc.. D'autre part, bien qu'on ait considéré au terme d'observations expérimentales et de calculs théoriques qu'il est suffisant en pratique de neutraliser les effets d'un parasite ayant une origine unique , qui est le résultat de la somme vectorielle des signaux délivrés via tous les chemins parasites, il va de soi que certaines applications ou certaines architectures de circuit peuvent nécessiter de compenser les effets perturbateurs de signaux parasites d'origines différentes (par exemple émis avant et après un amplificateur à gain variable). Il faut dans ce cas prévoir deux signaux de compensation, et il est préférable que chaque parasite d'origine différente soit traité par un circuit de compensation dédié. Dans ce cas on injecte dans le VCO deux signaux de compensation ajustable l'un indépendamment de l'autre, voire plus, qui peuvent être additionnés en amont de leur point d'injection.

Enfin, bien que l'invention ait été décrite dans ce qui précède en relation avec un circuit de modulation de phase IQ, il va de soi que le champ d'application de l'invention concerne également les autres circuits de modulation, notamment de modulation d'amplitude AM et de modulation d'amplitude et de phase, qui génèrent également des harmoniques parasites.

## Revendications

1. Circuit RF (RFCT) comprenant :

    - un oscillateur contrôlé en tension (VCO) délivrant un signal RF (V1, F1),
    - une boucle à verrouillage de phase (PLL) pour contrôler l'oscillateur contrôlé en tension (VCO),
    - un circuit de modulation (TXCR) recevant le signal RF (V1, F1) et délivrant un signal modulé (RFSx) comprenant au moins une composante harmonique (H1, H2, H4) de fréquence égale ou proche de celle du signal RF délivré par l'oscillateur contrôlé en tension, la composante harmonique étant susceptible de perturber le fonctionnement de l'oscillateur contrôlé en tension par effet d'accrochage en fréquence,

    **caractérisé en ce qu'**il comprend

    - un circuit de compensation (OCMPCT, COMPCT1, COMPCT2, CCMPCT3) de l'effet d'accrochage en fréquence, comprenant une entrée recevant au moins la composante harmonique perturbatrice (H1, H2, H4) et des moyens pour modifier la phase et l'amplitude de la composante harmonique afin de délivrer un signal (Bcomp) de compensation de l'effet d'accrochage en fréquence ayant une fréquence se trouvant dans la bande passante de l'oscillateur contrôlé en tension, et
    - des mayens d' injection du signal de compensation (Bcomp) dans le coeur de l'oscillateur contrôlé en tension.

2. Circuit RF selon la revendication 1, dans lequel le circuit de compensation (COMPCT, COMPCT1, COMPCT2, COMPCT3) est ajusté en amplitude et en phase de manière que le signal de compensation injecté dans l'oscillateur contrôlé en tension présente une amplitude sensiblement égale à l'amplitude d'un signal parasite (Anet) résultant de l'injection involontaire dans l'oscillateur contrôlé en tension, par au moins un chemin parasite (SA1, SA2, SA3,...SAn), de la composante harmonique perturbatrice, et une phase opposée à celle du signal parasite.

3. Circuit RF selon l'une des revendications 1 et 2, dans lequel le circuit de compensation (COMPCT1) est un circuit non symétrique qui délivre un signal de compensation ayant une composante unique qui est injectée en un point de l'oscillateur contrôlé en tension.

4. Circuit RF selon l'une des revendications 1 et 2, dans lequel le circuit de compensation (QOMPCT2) est un circuit non symétrique qui délivre un signal de compensation ayant deux composantes (Bccxttp1, Bccxnp2) qui sont injectées en deux points différents de l'oscillateur contrôlé en tension.

5. Circuit RF selon l'une des revendications 1 et 2, dans lequel le circuit de compensation (COMPCT3) est un circuit symétrique qui délivre un signal de compensation ayant deux composantes (Bcomp1', Bcomp2') en opposition de phase qui sont injectées en deux points différents de l'oscillateur contrôlé en tension.

6. Circuit RF selon l'une des revendications 1 à 5, dans lequel le circuit de compensation reçoit en entrée une composante harmonique (H2, H4) prélevée dans le circuit de modulation.

7. Circuit RF selon la revendication 6, dans lequel le circuit de compensation reçoit en entrée une composante harmonique (H2, H4) prélevée dans un amplificateur de sortie (RFAMP) du circuit de modulation.

8. Circuit RF selon l'une des revendications 1 à 5, dans lequel le circuit de compensation reçoit en entrée une composante harmonique délivrée par un circuit de génération d' harmonique distinct du circuit de modulation.

9. Circuit RF selon l'une des revendications 1 à 8, dans lequel le circuit de compensation comprend un circuit déphaseur (PSN) pour modifier la phase de la composante harmonique reçue en entrée.

10. Circuit RF selon l'une des revendications 1 à 8, dans lequel le circuit de compensation comprend un circuit déphaseur (QGEN1) recevant la composante harmonique perturbatrice et délivrant deux signaux en quadrature de phase.

11. Circuit RF selon l'une des revendications 1 à 8, dans lequel le circuit de compensation comprend un circuit déphaseur (QGEN2) recevant la composante harmonique perturbatrice et délivrant des signaux en quadrature et en opposition de phase.

12. Circuit RF selon la revendication 11, dans lequel le circuit déphaseur (QGEN2) comprend un pont équilibré de résistances et de capacités qui est peu sensible à la température.

13. Circuit RF selon l'une des revendications 1 à 12, dans lequel le circuit de compensation (COMPCT, COMPCT1, COMPCT2, COMPCT3) comprend au moins un circuit atténuateur (ATTC, IAT1, IBAT1, QAT1, QBAT1, IAT2, IBAT2 , QAT2 , QBAT2) pour modifier l'amplitude de la composante harmonique reçue en entrée.

14. Circuit RF selon la revendication 13, dans lequel le circuit atténuateur comprend des résistances ou des capacités ajustables ou une combinaison de ces éléments.

15. Circuit RF selon la revendication 13, comprenant un groupe d'au moins deux circuits atténuateurs (IAT1, IBAT1, QAT1, QBAT1, IAT2, IBAT2, QAT2, QBAZ2) dont les sorties sont additionnés pour contrôler la phase et l'amplitude du signal de compensation.

16. Circuit RF selon la revendication 15, comprenant un groupe de circuits atténuateurs (IAT1/QAT1, IBAT1/QBAT1) ayant leurs sorties additionnées et recevant en entrée des signaux en quadrature de phase issus de la composante harmonique perturbatrice.

17. Circuit RF selon la revendication 15, comprenant un groupe de circuits atténuateurs (IAT2/IBRT2/QAT2/QBM2) ayant leurs sorties additionnées et recevant en entrée des signaux en quadrature de phase et des signaux en opposition de phase issus de la composante harmonique perturbatrice.

18. Circuit RF selon l'une des revendications 15 à 17, dans lequel un circuit atténuateur (IAT1, IBAT1, QAT1, QBAT1, IAT2, IBAT2, QAT2, QBAT2) comprend des capacités ajustables électriquement ou des résistances ajustables électriquement, qui sont ajustées par des signaux analogiques délivrés par un convertisseur numérique/analogique.

19. Circuit RF selon la revendication 18, dans lequel des données numériques d'ajustage des capacités du circuit atténuateur sont stockées dans des cellules mémoire (NVREG) et sont appliquées au convertisseur numérique/analogique.

20. Circuit RF selon l'une des revendications 1 à 19, dans lequel le signal de compensation (Bcomp) est injecté sur une borne d'un composant actif (T1, T2) de l'oscillateur contrôlé en tension.

21. Circuit RF selon l'une des revendications 1 à 19, dans lequel le signal de compensation (Bcomp) est injecté sur une borne d'un composant passif (C1, C2) de l'oscillateur contrôlé en tension.

22. Circuit RF selon l'une des revendications 1 à 19, dans lequel les moyens d'injection du signal de compensation (Bcomp) comprennent une inductance d'injection (Lc) couplée à une inductance (L1) de l'oscillateur contrôlé en tension.

23. Procédé pour stabiliser le fonctionnement d'un oscillateur contrôlé en tension (VCD) piloté par une boucle à verrouillage de phase (PLL), l'oscillateur contrôlé en tension délivrant un signal RF (V1, F1) et recevant par l'intermédiaire d'au moins un chemin parasite une composante harmonique (H1, H2, H4) de fréquence égale ou proche de celle du signal RF émis, susceptible de perturber le fonctionnement de l'oscillateur contrôlé en tension par effet d'accrochage en fréquence,
**caractérisé en ce qu'**il comprend l'injection, dans le coeur de l'oscillateur contrôlé en tension, d'un signal (Bcomp) de compensation de l'effet d'accrochage en fréquence, dont la fréquence se trouve dans la bande passante de l'oscillateur contrôlé en tension et dont la phase et l'amplitude sont ajustées de manière à neutraliser les effets perturbateurs de la composante harmonique.

24. Procédé selon la revendication 23, dans lequel le signal de compensation est ajusté en amplitude et en phase de manière à présenter une amplitude sensiblement égale à l'amplitude d'un signal parasite (Anet) résultant de l'injection involontaire dans l'oscillateur contrôlé en tension, par au moins un chemin parasite (SA1, SA2, SA3,... SAn), de la composante harmonique perturbatrice, et une phase opposée à celle du signal parasite.

25. Procédé selon l'une des revendications 23 et 24, comprenant l'injection non symétrique, en un point de l'oscillateur contrôlé en tension, d'un signal de compensation ayant une composante unique.

26. Procédé selon l'une des revendications 23 et 24, comprenant l'injection d'un signal de compensation ayant deux composantes (Bcomp1, Bcomp2), et l'injection non symétrique de ces composantes en deux points différents de l'oscillateur contrôlé en tension.

27. Procédé selon l'une des revendications 23 et 24, comprenant l'injection d'un signal de compensation ayant deux composantes (Bcomp1', Bcomp2') en opposition de phase, et l'injection de ces deux composantes en deux points différents de l'oscillateur contrôlé en tension.

28. Procédé selon l'une des revendications 23 à 27, dans lequel le signal de compensation est généré à partir d'au moins une composante harmonique (H1, H2, H4) prélevée dans le circuit de modulation.

29. Procédé selon la revendication 28, dans lequel le signal de compensation est généré à partir d'au moins une composante harmonique (H2, H4) prélevée dans un amplificateur (RFAMP) d'un circuit de modulation d'où est émise la composante harmonique perturbatrice.

30. Procédé selon l'une des revendications 23 à 29, dans lequel le signal de compensation est généré à partir d'une composante harmonique produite par un circuit de génération d'harmonique.

31. Procédé selon l'une des revendications 23 à 30, dans lequel la phase du signal de compensation est ajustée au moyen d'un circuit déphaseur (PSN).

32. Procédé selon la revendication 31, dans lequel l'amplitude du signal de compensation est ajustée au moyen d'un circuit atténuateur (ATTC) comprenant des résistances ou des capacités ajustables ou une combinaison de ces éléments.

**33.** Procédé selon l'une des revendication 23 à 30, dans lequel l'amplitude et la phase du signal de compensation, sont ajustées au moyen d'un groupe d'au moins deux circuits atténuateurs (IAT1, IBAT1, QAT1, QBAT1, IAT2, IBAT2, QAT2, QBAT2) dont les sorties sont additionnées.

**34.** Procédé selon la revendication 33, dans lequel l'amplitude et la phase du signal de compensation sont ajustées au moyen d'un groupe de circuits atténuateurs (IAT1/QAT1, IBAT1/QHAT1) ayant leurs sorties additionnées et recevant en entrée des signaux en quadrature de phase issus de la composante harmonique perturbatrice.

**35.** Procédé selon la revendication 33, dans lequel l'amplitude et la phase du signal de compensation sont ajustées au moyen d'un groupe de circuits atténuateurs (IAT2/IBAT2/QKT2/QBAT2) ayant leurs sorties additionnées et recevant en entrée des signaux en quadrature de phase et des signaux en opposition de phase issus de la composante harmonique perturbatrice.

**36.** Procédé selon la revendication 35, dans lequel les signaux en quadrature de phase et en apposition de phase sont générés au moyen d'un circuit déphaseur comprenant un pont équilibré de résistances et de capacités qui est peu sensible à la température.

**37.** Procédé selon l'une des revendication 33 à 35, dans lequel un circuit atténuateur (IAT1, IRAT1, QAT1, QBAT1, IAT2, IBAT2, QAT2, QBAT2) comprend des capacités ajustables électriquement ou des résistances ajustables électriquement qui sont ajustées par des signaux analogiques issus de données numériques d'ajustage.

**38.** Procédé selon la revendication 37, dans lequel les données numériques d'ajustage sont stockées dans des cellules mémoire (NVRBG) .

**39.** Procédé selon l'une des revendications 23 à 38, dans lequel le signal de compensation (Bcomp) est injecté sur une borne d'un composant actif (T1, T2) de l'oscillateur contrôlé en tension.

**40.** Procédé selon l'une des revendications 23 à 38, dans lequel le signal de compensation (Bcomp) est injecté sur une borne d'un composant passif (C1, C2) de l'oscillateur contrôlé en tension.

**41.** Procédé selon l'une des revendications 23 à 38, dans lequel le signal de compensation (Bcomp) est injecté par couplage inductif.

## Claims

**1.** An RF circuit (RFCT) comprising:

- a voltage controlled oscillator (VCO) delivering an RF signal (V1, F1),
- a phase locked loop (PLL) to control the voltage controlled oscillator (VCO),
- a modulation circuit (TXCT) receiving the RF signal (V1, F1) and delivering a modulated signal (RFSx) comprising at least one harmonic component (H1, H2, H4) of a frequency equal or proximate to that of the RF signal delivered by the voltage controlled oscillator, the harmonic component being capable of disturbing the operation of the voltage controlled oscillator by injection pulling,

**characterised in that** it comprises:

- an injection pulling compensation circuit (COMPCT, COMPCT1, COMPCT2, COMPCT3), comprising one input receiving at least the disturbing harmonic component (H1, H2, H4) and means for modifying the phase and the amplitude of the harmonic component to deliver an injection pulling compensation signal (Bcomp) having a frequency located within the bandwidth of the voltage controlled oscillator, and
- means for injecting the compensation signal (Bcomp) into the voltage controlled oscillator.

**2.** RF circuit according to claim 1, wherein the compensation circuit (COMPCT, COMPCT1, COMPCT2, COMPCT3) is amplitude and phase adjusted such that the compensation signal injected into the voltage controlled oscillator has an amplitude substantially equal to the amplitude of a spurious signal (Anet) resulting from the involuntary injection into the voltage controlled oscillator, through at least one spurious path (SA1, SA2, SA3,...SAn), of the disturbing harmonic component, and a phase opposite that of the spurious signal.

3. RF circuit according to one of claims 1 and 2, wherein the compensation circuit (COMPCT1) is a single ended circuit that delivers a compensation signal having a unique component that is injected at one point of the voltage controlled oscillator.

4. RF circuit according to one of claims 1 and 2, wherein the compensation circuit (COMPCT2) is a single ended circuit that delivers a compensation signal having two components (Bcomp1, Bcomp2) that are injected at two different points of the voltage controlled oscillator.

5. RF circuit according to one of claims 1 and 2, wherein the compensation circuit (COMPCT3) is a balanced circuit that delivers a compensation signal having two components (Bcomp1' Bcomp2') in opposite phase that are injected at two different points of the voltage controlled oscillator.

6. RF circuit according to one of claims 1 to 5, wherein the compensation circuit receives at input a harmonic component (H2, H4) taken off in the modulation circuit.

7. RF circuit according to claim 6, wherein the compensation circuit receives at input a harmonic component (H2, H4) taken off in an output amplifier (RFAMP) of the modulation circuit.

8. RF circuit according to one of claims 1 to 5, wherein the compensation circuit receives at input a harmonic component delivered by a harmonic generating circuit distinct from the modulation circuit.

9. RF circuit according to one of claims 1 to 8, wherein the compensation circuit comprises a phase-shift circuit (PSN) to modify the phase of the harmonic component received at input.

10. RF circuit according to one of claims 1 to 8, wherein the compensation circuit comprises a phase-shift circuit (QGEN1) receiving the disturbing harmonic component and delivering two phase quadrature signals.

11. RF circuit according to one of claims 1 to 8, wherein the compensation circuit comprises a phase-shift circuit (QGEN2) receiving the disturbing harmonic component and delivering phase quadrature and opposite phase signals.

12. RF circuit according to claim 11, wherein the phase-shift circuit (QGEN2) comprises a balanced bridge of resistors and capacitors that is quite insensitive to the temperature.

13. RF circuit according to one of claims 1 to 12, wherein the compensation circuit (COMPCT, COMPCT1, COMPCT2, COMPCT3) comprises at least one attenuator circuit (ATTC, IAT1, IBAT1, QAT1, QBAT1, IAT2, IBAT2, QAT2, QBAT2) to modify the amplitude of the harmonic component received at input.

14. RF circuit according to claim 13, wherein the attenuator circuit comprises adjustable resistors or capacitors or a combination of these elements.

15. RF circuit according to claim 13, comprising a group of at least two attenuator circuits (IAT1, IBAT1, QAT1, QBAT1, IAT2, IBAT2, QAT2, QBAT2) the outputs of which are added up to control the phase and the amplitude of the compensation signal.

16. RF circuit according to claim 15, comprising a group of attenuator circuits (IAT1/QAT1, IBAT1/QBAT1) having their outputs added up and receiving at input phase quadrature signals coming from the disturbing harmonic component.

17. RF circuit according to claim 15, comprising a group of attenuator circuits (IAT2/IBAT2/QAT2/QBAT2) having their outputs added up and receiving at input phase quadrature and opposite phase signals coming from the disturbing harmonic component.

18. RF circuit according to one of claims 15 to 17, wherein an attenuator circuit (IAT1, IBAT1, QAT1, QBAT1, IAT2, IBAT2, QAT2, QBAT2) comprises electrically adjustable capacitors or electrically adjustable resistors, which are adjusted by analog signals delivered by a digital to analog converter.

19. RF circuit according to claim 18, wherein digital data for adjusting the capacitors of the attenuator circuit are stored in memory cells (NVREG) and are applied to the digital to analog converter.

**20.** RF circuit according to one of claims 1 to 19, wherein the compensation signal (Bcomp) is injected onto one terminal of an active component (T1, T2) of the voltage controlled oscillator.

**21.** RF circuit according to one of claims 1 to 19, wherein the compensation signal (Bcomp) is injected onto one terminal of a passive component (C1, C2) of the voltage controlled oscillator.

**22.** RF circuit according to one of claims 1 to 19, wherein the means for injecting the compensation signal (Bcomp) comprise an injection inductor (Lc) coupled to an inductor (L1) of the voltage controlled oscillator.

**23.** Method for stabilising the operation of a voltage controlled oscillator (VCO) driven by a phase locked loop (PLL), the voltage controlled oscillator delivering an RF signal (V1, F1) and receiving through at least one spurious path a harmonic component (H1, H2, H4) of a frequency equal or proximate to that of the RF signal sent, capable of disturbing the operation of the voltage controlled oscillator by injection pulling, **characterised in that** it comprises the injection, into the core of the voltage controlled oscillator, of an injection pulling compensation signal (Bcomp), the frequency of which is located within the bandwidth of the voltage controlled oscillator and the phase and the amplitude of which are adjusted so as to neutralise the disturbing effects of the harmonic component.

**24.** Method according to claim 23, wherein the compensation signal is amplitude and phase adjusted so as to have an amplitude substantially equal to the amplitude of a spurious signal (Anet) resulting from the involuntary injection into the voltage controlled oscillator, through at least one spurious path (SA1, SA2, SA3,... SAn), of the disturbing harmonic component, and a phase opposite that of the spurious signal.

**25.** Method according to one of claims 23 and 24, comprising the single ended injection, at one point of the voltage controlled oscillator, of a compensation signal having a unique component.

**26.** Method according to one of claims 23 and 24, comprising the injection of a compensation signal having two components (Bcomp1, Bcomp2), and the single ended injection of these components at two different points of the voltage controlled oscillator.

**27.** Method according to one of claims 23 and 24, comprising the injection of a compensation signal having two components (Bcomp1', Bcomp2') in opposite phase, and the injection of these two components at two different points of the voltage controlled oscillator.

**28.** Method according to one of claims 23 to 27, wherein the compensation signal is generated from at least one harmonic component (H1, H2, H4) taken off in the modulation circuit.

**29.** Method according to claim 28, wherein the compensation signal is generated from at least one harmonic component (H2, H4) taken off in an amplifier (RFAMP) of a modulation circuit from which the disturbing harmonic component is sent.

**30.** Method according to one of claims 23 to 29, wherein the compensation signal is generated from one harmonic component produced by a harmonic generating circuit.

**31.** Method according to one of claims 23 to 30, wherein the phase of the compensation signal is adjusted by means of a phase-shift circuit (PSN).

**32.** Method according to claim 31, wherein the amplitude of the compensation signal is adjusted by means of an attenuator circuit (ATTC) comprising adjustable resistors or capacitors or a combination of these elements.

**33.** Method according to one of claims 23 to 30, wherein the amplitude and the phase of the compensation signal are adjusted by means of a group of at least two attenuator circuits (IAT1, IBAT1, QAT1, QBAT1, IAT2, IBAT2, QAT2, QBAT2) the outputs of which are added up.

**34.** Method according to claim 33, wherein the amplitude and the phase of the compensation signal are adjusted by means of a group of attenuator circuits (IAT1/QAT1, IBAT1/QBAT1) having their outputs added up and receiving at input phase quadrature signals coming from the disturbing harmonic component.

**35.** Method according to claim 33, wherein the amplitude and the phase of the compensation signal are adjusted by means of a group of attenuator circuits (IAT2/IBAT2/QAT2/QBAT2) having their outputs added up and receiving at input phase quadrature and opposite phase signals coming from the disturbing harmonic component.

**36.** Method according to claim 35, wherein the phase quadrature and opposite phase signals are generated by means of a phase-shift circuit comprising a balanced bridge of resistors and capacitors that is quite insensitive to the temperature.

**37.** Method according to one of claims 33 to 35, wherein an attenuator circuit (IAT1, IBAT1, QAT1, QBAT1, IAT2, IBAT2, QAT2, QBAT2) comprises electrically adjustable capacitors or electrically adjustable resistors that are adjusted by analog signals coming from adjustment digital data.

**38.** Method according to claim 37, wherein the adjustment digital data are stored in memory cells (NVREG).

**39.** Method according to one of claims 23 to 38, wherein the compensation signal (Bcomp) is injected onto one terminal of an active component (T1, T2) of the voltage controlled oscillator.

**40.** Method according to one of claims 23 to 38, wherein the compensation signal (Bcomp) is injected onto one terminal of a passive component (C1, C2) of the voltage controlled oscillator.

**41.** Method according to one of claims 23 to 38, wherein the compensation signal (Bcomp) is injected by inductive coupling.

**Patentansprüche**

**1.** HF-Schaltung (HFCT), umfassend:

- einen spannungsgesteuerten Oszillator (VCO), der ein HF-Signal (V1, F1) liefert,
- eine Phasenverriegelungsschleife (PLL), zur Steuerung des spannungsgesteuerten Oszillators (VCO);
- eine Modulationsschaltung (TXCT), die das HF-Signal (V1, F1) empfängt und ein moduliertes Signal (HFSx), welches mindestens eine harmonische Komponente (H1, H2, H4) enthält, deren Frequenz gleich oder nahe der des von dem spannungsgesteuerten Oszillator gelieferten HF-Signals ist, wobei die harmonische Komponente die Funktionsweise des spannungsgesteuerten Oszillators durch Frequenzübertönung stören kann,

**dadurch gekennzeichnet, dass** sie Folgendes umfasst:

- eine Kompensationsschaltung (COMPCT, COMPCT1, COMPCT2, COMPCT3) zum Frequenzübertönen, umfassend einen Eingang, der mindestens die störende harmonische Komponente (H1, H2, H4) empfängt, und Mittel zum Modifizieren der Phase und der Amplitude der harmonischen Komponente, um ein Signal (Bcomp) zu liefern, das den Frequenzübertönungseffekt kompensiert und eine Frequenz aufweist, welche sich in dem Band des spannungsgesteuerten Oszillators befindet, und
- Mittel zum Eingeben des Kompensationssignals (Bcomp) in den spannungsgesteuerten Oszillator.

**2.** HF-Schaltung nach Anspruch 1, in dem die Kompensationsschaltung (COMPCT, COMPCT1, COMPCT2, COMPCT3) in der Amplitude und der Phase so angepasst ist, dass das in den spannungsgesteuerten Oszillator eingegebene Kompensationssignal eine Amplitude aufweist, die im Wesentlichen gleich der Amplitude eines Parasitensignals (Anet) ist, welches sich aus der unbeabsichtigten Eingabe über mindestens einen parasitären Pfad (SA1, SA2, SA3; ... San) der störenden harmonischen Komponente in den spannungsgesteuerten Oszillator und einer der Phase des Parasitensignals entgegengesetzten Phase ergibt.

**3.** HF-Schaltung nach einem der Ansprüche 1 und 2, in der die Kompensationsschaltung (COMPCT1) eine nicht symmetrische Schaltung ist, welche ein Kompensationssignal liefert, das eine einzige Komponente aufweist und an einer Stelle in den spannungsgesteuerten Oszillator eingegeben wird.

**4.** HF-Schaltung nach einem der Ansprüche 1 und 2, in der die Kompensationsschaltung (COMPCT2) eine nicht symmetrische Schaltung ist, welche ein Kompensationssignal liefert, das zwei Komponenten (Bcomp1, Bcomp2) aufweist, die an zwei unterschiedlichen Stellen in den spannungsgesteuerten Oszillator eingegeben werden.

5. HF-Schaltung nach einem der Ansprüche 1 und 2, in der die Kompensationsschaltung (COMPCT3) eine symmetrische Schaltung ist, welche ein Kompensationssignal liefert, das zwei in der Phase entgegengesetzten Komponenten (Bcomp1', Bcomp2') aufweist, die an zwei unterschiedlichen Stellen in den spannungsgesteuerten Oszillator eingegeben werden.

6. HF-Schaltung nach einem der Ansprüche 1 bis 5, in dem die Kompensationsschaltung am Eingang eine aus der Modulationsschaltung erhaltene harmonische Komponente (H2, H4) empfängt.

7. HF-Schaltung nach Anspruch 6, in der die Kompensationsschaltung am Eingang eine aus einem Ausgangsverstärker (RFAMP) der Modulationsschaltung erhaltene harmonische Komponente (H2, H4) empfängt.

8. HF-Schaltung nach einem der Ansprüche 1 bis 5, in, der die Kompensationsschaltung am Eingang eine von einer von der Modulationsschaltung getrennten Schaltung zur Erzeugung der Harmonischen erhaltene harmonische Komponente empfängt.

9. HF-Schaltung nach einem der Ansprüche 1 bis 8, in der die Kompensationsschaltung eine Phasenverschiebungsschaltung (PSN) zum Modifizieren der Phase der am Eingang empfangenen harmonischen Komponente umfasst.

10. HF-Schaltung nach einem der Ansprüche 1 bis 8, in der die Kompensationsschaltung eine Phasenverschiebungsschaltung (QGEN1) umfasst, die die störende harmonische Komponente empfängt und zwei Phasenquadratursignale liefert.

11. HF-Schaltung nach einem der Ansprüche 1 bis 8, in der die Kompensationsschaltung eine Phasenverschiebungsschaltung (QGEN2) umfasst, die die störende harmonische Komponente empfängt und Quadratursignale und Signale mit entgegengesetzter Phase liefert.

12. HF-Schaltung nach Anspruch 11, in der die Phasenverschiebungsschaltung (QGEN2) eine Brücke umfasst, deren Widerstand und Kondensator ausgeglichen ist und die gegenüber Temperatur wenig empfindlich ist.

13. HF-Schaltung nach einem der Ansprüche 1 bis 12, in der die Kompensationsschaltung (COMPCT, COMPCT1, COMPCT2, COMPCT3) mindestens eine Dämpfungsschaltung (ATTC, IAT1, IBAT1, QAT1, QBAT1, IAT2, IBAT2, QAT2, QBAT2) zum Modifizieren der Amplitude der am Eingang empfangenen harmonischen Komponente.

14. HF-Schaltung nach Anspruch 13, in der die Dämpfungsschaltung einstellbare Widerstände oder Kondensatoren oder eine Kombination dieser Elemente umfasst.

15. HF-Schaltung nach Anspruch 13, umfassend eine Gruppe aus mindestens zwei Dämpfungsschaltungen (IAT1, IBAT1, QAT1, QBAT1, IAT2, IBAT2, QAT2, QBAT2), von denen die Ausgänge verbunden sind, um die Phase und Amplitude des Kompensationssignals zu steuern.

16. HF-Schaltung nach Anspruch 15, umfassend eine Gruppe aus Dämpfungsschaltungen (IAT1/QAT1, IBAT1/QBAT1), deren Ausgänge verbunden sind und die am Eingang Phasenquadratursignale empfangen, die von der störenden harmonischen Komponente ausgegeben werden.

17. HF-Schaltung nach Anspruch 15, umfassend eine Gruppe aus Dämpfungsschaltungen (IAT2/IBAT2/QAT2/QBAT2), deren Ausgänge verbunden sind und die am Eingang Phasenquadratursignale und Signale entgegengesetzter Phase empfangen, die von der störenden harmonischen Komponente ausgegeben werden.

18. HF-Schaltung nach einem der Ansprüche 15 bis 17, in der eine Dämpfungsschaltung (IAT1, IBAT1, QAT1, QBAT1, IAT2, IBAT2, QAT2, QBAT2) elektrisch einstellbare Kondensatoren oder elektrisch einstellbare Widerstände umfasst, die durch Analogsignale eingestellt werden, welche von einem Digital/Analog-Wandler geliefert werden.

19. HF-Schaltung nach Anspruch 18, in der die Digitaldaten zum Einstellen der Kondensatoren der Dämpfungsschaltung in Speicherzellen (NVREG) gespeichert sind und an den Digital/Analog-Wandler angelegt werden.

20. HF-Schaltung nach einem der Ansprüche 1 bis 19, in der das Kompensationssignal (Bcomp) an einem Anschluss einer aktiven Komponente (T1, T2) des spannungsgesteuerten Oszillators eingegeben wird.

**21.** HF-Schaltung nach einem der Ansprüche 1 bis 19, in der das Kompensationssignal (Bcomp) an einem Anschluss einer passiven Komponente (C1, C2) des spannungsgesteuerten Oszillators eingegeben wird.

**22.** HF-Schaltung nach einem der Ansprüche 1 bis 19, in der die Mittel zum Eingeben des Kompensationssignals (Bcomp) eine Eingabeinduktivität (Lc) umfassen, die mit einer Induktivität (L1) des spannungsgesteuerten Oszillators verbunden ist.

**23.** Verfahren zum Stabilisieren der Funktionsweise eines spannungsgesteuerten Oszillators (VCO), der von einer Phasenverriegelungsschleife (PLL) gesteuert wird, wobei der spannungsgesteuerte Oszillator ein HF-Signal (V1, F1) liefert und über mindestens einen parasitären Pfad eine harmonische Komponente (H1, H2, H4) empfängt, deren Frequenz gleich oder nahe dem ausgegebenen HF-Signal ist, welches die Funktionsweise des spannungsgesteuerten Oszillators durch Frequenzübertönung stören kann,
**dadurch gekennzeichnet, dass** es die Eingabe eines Signals (Bcomp) zur Kompensation der Frequenzübertonung in den spannungsgesteuerten Oszillator umfasst, dessen Frequenz sich im Band des spannungsgesteuerten Oszillators befindet und dessen Phase und Amplitude so eingestellt sind, dass sie die störenden Wirkungen der harmonischen Komponente neutralisieren.

**24.** Verfahren nach Anspruch 23, in dem das Kompensationssignal in Amplitude und Phase so eingestellt ist, dass es eine Amplitude aufweist, die im Wesentlichen gleich der Amplitude eines Parasitensignals (Anet) ist, welches sich aus der unbeabsichtigten Eingabe der störenden harmonischen Komponente über mindestens einen parasitären Pfad (SA1, SA2, SA3, ... SAn) in den spannungsgesteuerten Oszillator und einer der Phase des Parasitensignals entgegengesetzten Phase ergibt.

**25.** Verfahren nach einem der Ansprüche 23 und 24, umfassend die nicht symmetrische Eingabe eines Kompensationssignals mit einer einzigen Komponente an einer Stelle des spannungsgesteuerten Oszillators.

**26.** Verfahren nach einem der Ansprüche 23 und 24, umfassend die Eingabe eines Kompensationssignals mit zwei Komponenten (Bcomp1, Bcomp2) und die nicht symmetrische Eingabe dieser Komponenten an zwei unterschiedlichen Stellen des spannungsgesteuerten Oszillators.

**27.** Verfahren nach einem der Ansprüche 23 und 24, umfassend die Eingabe eines Kompensationssignals mit zwei in der Phase entgegengesetzten Komponenten (Bcomp1', Bcomp2') und die Eingabe dieser beiden Komponenten an zwei unterschiedlichen Stellen des spannungsgesteuerten Oszillators.

**28.** Verfahren nach einem der Ansprüche 23 bis 27, in dem das Kompensationssignal aus mindestens einer harmonischen Komponente (H1, H2, H4), die aus der Modulationsschaltung erhalten wurde, erzeugt wird.

**29.** Verfahren nach Anspruch 28, in dem das Kompensationssignal aus mindestens einer harmonischen Komponente (H2, H4) erzeugt wird, die aus einer Verstärkungsschaltung (RFAMP) einer Modulationsschaltung erhalten wird, von der die störende harmonische Komponente ausgegeben wird.

**30.** Verfahren nach einem der Ansprüche 23 bis 29, in dem das Kompensationssignal aus einer harmonischen Komponente erzeugt wird, die von einer Schaltung zur Erzeugung der Harmonischen erzeugt wird.

**31.** Verfahren nach einem der Ansprüche 23 bis 30, in dem die Phase des Kompensationssignals mittels einer Phasenverschiebungsschaltung (PSN) eingestellt wird.

**32.** Verfahren nach Anspruch 31, in der die Amplitude des Kompensationssignals mittels einer Dämpfungsschaltung (ATTC) eingestellt wird, die einstellbare Widerstände oder Kondensatoren oder eine Kombination dieser Elemente umfasst.

**33.** Verfahren nach einem der Ansprüche 23 bis 30, in dem die Amplitude und die Phase des Kompensationssignals mittels einer Gruppe aus mindestens zwei Dämpfungsschaltungen (IAT1, IBAT1, QAT1, IAT2, IBAT2, QAT2, QBAT2) eingestellt werden, von denen die Eingänge verbunden sind.

**34.** Verfahren nach Anspruch 33, in dem die Amplitude und die Phase des Kompensationssignals mittels einer Gruppe aus Dämpfungsschaltungen (IAT1/QAT1, IBAT1/QBAT1) eingestellt werden, deren Ausgänge verbunden sind und am Eingang Phasenquadratursignale empfangen, die von der störenden harmonischen Komponente ausgegeben werden.

**35.** Verfahren nach Anspruch 33, in dem die Amplitude und die Phase des Kompensationssignals mittels einer Gruppe aus Dämpfungsschaltungen (IAT2/IBAT2/QAT2/QBAT2) eingestellt werden, deren Ausgänge verbunden sind und die am Eingang Phasenquadratursignale und Signale entgegengesetzter Phase empfangen, die von der störenden harmonischen Komponente ausgegeben werden.

**36.** Verfahren nach Anspruch 35, in der die Phasenquadratursignale und die Signale entgegengesetzter Phase eine Brücke umfassen, deren Widerstände und Kondensatoren ausgeglichen sind und die gegenüber - Temperatur wenig empfindlich ist.

**37.** Verfahren nach einem der Ansprüche 33 bis 35, in dem die eine Dämpfungsschaltung (IAT1, IBAT1, QAT1, IAT2, IBAT2, QAT2, QBAT2) elektrisch einstellbare Kondensatoren oder elektrisch einstellbare Widerstände umfasst, die durch Analogsignale eingestellt werden, welche von Digitaleinstelldaten ausgegeben werden.

**38.** Verfahren nach Anspruch 37, in dem die Digitaleinstelldaten in Speicherzellen (NVREG) gespeichert sind.

**39.** Verfahren nach einem der Ansprüche 23 bis 38, in dem das Kompensationssignal (Bcomp) an einem Anschluss einer aktiven Komponente (T1, T2) des spannungsgesteuerten Oszillators eingegeben wird.

**40.** Verfahren nach einem der Ansprüche 23 bis 38, in dem das Kompensationssignal (Bcomp) an einem Anschluss einer passiven Komponente (C1, C2) des spannungsgesteuerten Oszillators eingegeben wird.

**41.** Verfahren nach einem der Ansprüche 23 bis 38, in dem das Kompensationssignal (Bcomp) durch Induktionskoppeln eingegeben wird.

**Fig. 1**

**Fig. 2A**

**Fig. 2B**

**Fig. 3**

**Fig. 4**

**Fig. 5A**

**Fig. 5B**

**Fig. 6A**

**Fig. 6B**

**Fig. 7**

25

$A_{net} = A_1 + A_2 + A_3 \ldots + A_n$

B comp

VCO

$F_{REF}$ → PLL → LOOPF

SA$_n$ — $A_n$

SA$_3$ — $A_3$

$H_2, H_4$

$H_2, H_4$

SA$_2$ — $A_2$

$F_1 = KF_{RF}$

$H_2, H_4$

SA$_1$ — $A_1$

$S_X$ → $F_{RF}$

$H_2, H_4$

→ RFS$_X$

$H_2, H_4$

TXCT

COMPCT

B comp

RFAMP

**Fig. 8**

Vdd          Vdd

VCOL ← | → VCOR

P1L

B comp → | |←   $T_1$      $T_2$   →| |← B comp / $\overline{B comp}$   P1R

$\overline{V_1}$ ←          → $V_1$

$L_1$   Vdd

P3L          P3R

P2L

$L_C$

P2R

B comp → | |←   $C_1$   ◁   $C_2$   →| |← B comp / $\overline{B comp}$

$V_{cont}$

VCO

$V_{bias}$

**Fig. 9**

RFAMP

COMPCT1

P1L,P2L,P3L

H₂

PSN
90°

ATTC

B_comp

→ V_COL

→ V_COR

P1R,P2R,P3R

**Fig. 10**

PSN

CELL1

CELL2

H₂($\varphi$) →

R

C

R

C

R

C

R

C

→ H₂($\varphi'$)

**Fig. 11**

H₂($\varphi'$) →

ATTC

→ B_comp ($\varphi'$)

**Fig. 12**

COMPCT2

NVREG → DAC → IAT1

P1L,P2L,P3L

IBAT1

$B_{comp1}$ → $V_{COL}$

$H_2$ → QGEN1 +45°
−45°

P1R,P2R,P3R

QAT1

$B_{comp2}$ → $V_{COR}$

QBAT1

**Fig. 13**

QGEN1

$H_2$ → R → $H_2+45°$
C

C → $H_2-45°$
R

**Fig. 14**

(DAC)

$H_2\pm45°$

**Fig. 15**

IAT1,IBAT1,QAT1,QBAT1

| IAT1 OFF | IAT1 ON |
| IBAT1 ON | IBAT1 OFF |
| QAT1 ON | QAT1 ON |
| QBAT1 OFF | QBAT1 OFF |

| IAT1 OFF | IAT1 ON |
| IBAT1 ON | IBAT1 OFF |
| QAT1 OFF | QAT1 OFF |
| QBAT1 ON | QBAT1 ON |

$\varphi$

**Fig. 16**

QGEN2

H$_2$    0°    180°    $\overline{H_2}$

90°

270°

**Fig. 18**

(DAC)

**Fig. 19**

IAT2,IBAT2,QAT2,QBAT2

**Fig. 17**

EP 1 552 600 B1

**EP 1 552 600 B1**

**RÉFÉRENCES CITÉES DANS LA DESCRIPTION**

**Documents brevets cités dans la description**

- US 63211074 B
- US 5144260 A
- US 6281758 B